(19) Europäisches Patentamt
European Patent Office
Office européen des brevets

(11) **EP 1 882 268 B1**

(12) **EUROPEAN PATENT SPECIFICATION**

(45) Date of publication and mention of the grant of the patent:
**14.12.2016 Bulletin 2016/50**

(51) Int Cl.:
*H01L 21/20* *(2006.01)*        *H01L 21/8258* *(2006.01)*
*H01L 29/66* *(2006.01)*        *H01L 21/762* *(2006.01)*
*H01L 29/78* *(2006.01)*

(21) Application number: **06770525.1**

(22) Date of filing: **17.05.2006**

(86) International application number:
**PCT/US2006/019152**

(87) International publication number:
**WO 2006/125040 (23.11.2006 Gazette 2006/47)**

(54) **LATTICE-MISMATCHED SEMICONDUCTOR STRUCTURES WITH REDUCED DISLOCATION DEFECT DENSITIES AND RELATED METHODS FOR DEVICE FABRICATION**

HALBLEITERSTRUKTUREN MIT GITTERFEHLANPASSUNG UND VERMINDERTER VERSETZUNGSFEHLERDICHTE SOWIE VERFAHREN ZUR BAUELEMENTHERSTELLUNG

STRUCTURES SEMI-CONDUCTRICES AVEC INEGALITES SUR LES PARAMETRES DE MAILLE ET POSSEDANT DES DENSITES DE DISLOCATIONS REDUITES ET PROCEDES DE FABRICATION DUDIT DISPOSITIF

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.05.2005 US 681940 P**

(43) Date of publication of application:
**30.01.2008 Bulletin 2008/05**

(60) Divisional application:
**13155283.8 / 2 595 175**
**13155284.6 / 2 595 176**
**13155286.1 / 2 595 177**

(73) Proprietor: **Taiwan Semiconductor Manufacturing Company, Ltd.**
**Hsin-Chu,**
**300-77 (TW)**

(72) Inventors:
 • **CHENG, Zhiyuan**
   **Lincoln, MA 01773 (US)**
 • **CURRIE, Matthew, T.**
   **Brookline, MA 02445 (US)**
 • **LOCHTEFELD, Anthony J.**
   **Ipswich, MA 01938 (US)**
 • **FIORENZA, James**
   **Wilmington, MA 01887 (US)**
 • **LANGDO, Thomas A.**
   **Cambridge, MA 02141 (US)**
 • **BRAITHWAITE, Glyn**
   **Whitley Bay, Tyne and Wear NE25 9SF (GB)**

(74) Representative: **Atkinson, Jonathan David Mark et al**
**HGF Limited**
**1 City Walk**
**Leeds LS11 9DX (GB)**

(56) References cited:
**WO-A2-2005/122267        US-A- 5 221 413**
**US-A1- 2002 066 403        US-A1- 2003 045 017**
**US-A1- 2003 207 518**

 • **TANAKA SHIGEYASU ET AL: "Structural characterization of GaN laterally overgrown on a (111)Si substrate" APPLIED PHYSICS LETTERS, AIP, AMERICAN INSTITUTE OF PHYSICS, MELVILLE, NY, US, vol. 79, no. 7, 13 August 2001 (2001-08-13), pages 955-957, XP012030064 ISSN: 0003-6951**
 • **NAOI H ET AL: "Epitaxial lateral overgrowth of GaN on selected-area Si(111) substrate with nitrided Si mask" JOURNAL OF CRYSTAL GROWTH, ELSEVIER, AMSTERDAM, NL, vol. 248, February 2003 (2003-02), pages 573-577, XP004399950 ISSN: 0022-0248**

- NAM OK-HYUN ET AL: "Lateral epitaxy of low defect density GaN layers via organometallic vapor phase epitaxy" APPLIED PHYSICS LETTERS, AIP, AMERICAN INSTITUTE OF PHYSICS, MELVILLE, NY, US, vol. 71, no. 18, 3 November 1997 (1997-11-03), pages 2638-2640, XP012018948 ISSN: 0003-6951

- LANGDO T A ET AL: "High quality Ge on Si by epitaxial necking", APPLIED PHYSICS LETTERS, AIP, AMERICAN INSTITUTE OF PHYSICS, MELVILLE, NY, US, vol. 76, no. 25, 19 June 2000 (2000-06-19) , pages 3700-3702, XP012025569, ISSN: 0003-6951, DOI: 10.1063/1.126754

## Description

FIELD OF THE INVENTION

This invention relates generally to lattice-mismatched semiconductor heterostructures and, more specifically, to the selective channel material regrowth in connection with the integration of dissimilar semiconductor materials.

BACKGROUND OF THE INVENTION

The increasing operating speeds and computing power of microelectronic devices have recently given rise to the need for an increase in the complexity and functionality of the semiconductor structures from which that these devices are fabricated. Hetero-integration of dissimilar semiconductor materials, for example, III-V materials, such as gallium arsenide, gallium nitride, indium aluminum arsenide, and/or germanium with silicon or silicon-germanium substrate, is an attractive path to increasing the functionality and performance of the CMOS platform. In particular, heteroepitaxial growth can be used to fabricate many modern semiconductor devices where lattice-matched substrates are not commercially available or to potentially achieve monolithic integration with silicon microelectronics. Performance and, ultimately, the utility of devices fabricated using a combination of dissimilar semiconductor materials, however, depends on the quality of the resulting structure. Specifically, a low level of dislocation defects is important in a wide variety of semiconductor devices and processes, because dislocation defects partition an otherwise monolithic crystal structure and introduce unwanted and abrupt changes in electrical and optical properties, which, in turn, results in poor material quality and limited performance. In addition, the threading dislocation segments can degrade physical properties of the device material and can lead to premature device failure.

As mentioned above, dislocation defects typically arise in efforts to epitaxially grow one kind of crystalline material on a substrate of a different kind of material - often referred to as "heterostructure" - due to different crystalline lattice sizes of the two materials. This lattice mismatch between the starting substrate and subsequent layer(s) creates stress during material deposition that generates dislocation defects in the semiconductor structure.

Misfit dislocations form at the mismatched interface to relieve the misfit strain. Many misfit dislocations have vertical components, termed "threading segments," which terminate at the surface. These threading segments continue through all semiconductor layers subsequently added to the heterostructure. In addition, dislocation defects can arise in the epitaxial growth of the same material as the underlying substrate where the substrate itself contains dislocations. Some of the dislocations replicate as threading dislocations in the epitaxially grown material. Other kinds of dislocation defects include stacking faults, twin boundaries, and anti-phase boundaries. Such dislocations in the active regions of semiconductor devices, such as diodes, lasers and transistors, may significantly degrade performance.

To minimize formation of dislocations and associated performance issues, many semiconductor heterostructure devices known in the art have been limited to semiconductor layers that have very closely - e.g. within 0.1% - lattice-matched crystal structures. In such devices a thin layer is epitaxially grown on a mildly lattice-mismatched substrate. As long as the thickness of the epitaxial layer is kept below a critical thickness for defect formation, the substrate acts as a template for growth of the epitaxial layer, which elastically conforms to the substrate template. While lattice matching and near matching eliminate dislocations in a number of structures, there are relatively few lattice-matched systems with large energy band offsets, limiting the design options for new devices.

Accordingly, there is considerable interest in heterostructure devices involving greater epitaxial layer thickness and greater lattice misfit than known approaches would allow. For example, it has long been recognized that gallium arsenide grown on silicon substrates would permit a variety of new optoelectronic devices marrying the electronic processing technology of silicon VLSI circuits with the optical component technology available in gallium arsenide. See, for example, Choi et al, "Monolithic Integration of Si MOSFET's and GaAs MESFET's", IEEE Electron Device Letters, Vol. EDL-7, No. 4, April 1986. Highly advantageous results of such a combination include high-speed gallium arsenide circuits combined with complex silicon VLSI circuits, and gallium arsenide optoelectronic interface units to replace wire interconnects between silicon VLSI circuits. Progress has been made in integrating gallium arsenide and silicon devices. See, for example, Choi et al, "Monolithic Integration of GaAs/AlGaAs Double-Heterostructure LED's and Si MOSFET's" IEEE Electron Device Letters, Vol. EDL-7, No. 9, September 1986; Shichijo et al, "Co-Integration of GaAs MESFET and Si CMOS Circuits", IEEE Electron Device Letters, Vol. 9, No. 9, September 1988. However, despite the widely recognized potential advantages of such combined structures and substantial efforts to develop them, their practical utility has been limited by high defect densities in gallium arsenide layers grown on silicon substrates. See, for example, Choi et al, "Monolithic Integration of GaAs/AlGaAs LED and Si Driver Circuit", IEEE Electron Device Letters, Vol. 9, No. 10, October 1988 (p. 513). Thus, while basic techniques are known for integrating gallium arsenide and silicon devices, there exists a need for producing gallium arsenide layers having a low density of dislocation defects.

To control dislocation densities in highly-mismatched deposited layers, there are three known techniques: wafer bonding of dissimilar materials, substrate patterning, and composition grading. Bonding of two different semiconductors may yield satisfactory material quality. Due to the limited availability and high cost of large size Ge or III-V wafers, however, the approach may not be practical.

Techniques involving substrate patterning exploit the fact that the threading dislocations are constrained by geometry, i.e. that a dislocation cannot end in a crystal. If the free edge is brought closer to another free edge by patterning the substrate into smaller growth areas, then it is possible to reduce threading dislocation densities. In the past, a combination of substrate patterning and epitaxial lateral overgrowth ("ELO") techniques was demonstrated to greatly reduce defect densities in gallium nitride device, leading to fabrication of laser diodes with extended lifetimes. This process substantially eliminates defects in ELO regions but highly defective seed windows remain, necessitating repetition of the lithography and epitaxial steps to eliminate all defects. In a similar approach, pendeo-epitaxy eliminates substantially all defects in the epitaxial region proximate to the substrate but requires one lithography and two epitaxial growth steps. Furthermore, both techniques require the increased lateral growth rate of gallium nitride, which has not been demonstrated in all heteroepitaxial systems. Thus, a general defect-reduction process utilizing a minimum of lithography/ epitaxy steps that does not rely on increased lateral growth rates would be advantageous both to reduce process complexity and facilitate applicability to various materials systems.

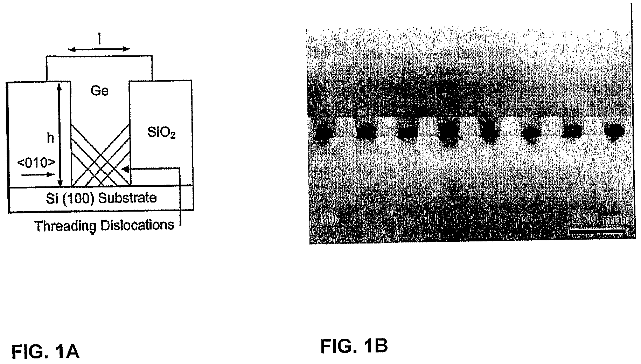

Another known technique termed "epitaxial necking" was demonstrated in connection with fabricating a Ge-on-Si heterostructure by Langdo et al. in "High Quality Ge on Si by Epitaxial Necking," Applied Physics Letters, Vol. 76, No. 25, April 2000. This approach offers process simplicity by utilizing a combination of selective epitaxial growth and defect crystallography to force defects to the sidewall of the opening in the patterning mask, without relying on increased lateral growth rates. Specifically, as shown in FIGS. 1A and 1B, in the (111)<110> diamond cubic slip system, misfit dislocations lie along <110> directions in the (100) growth plane while the threading segments rise up on (111) planes in <110> directions. Threading segments in <110> directions on the (111) plane propagate at a 45° angle to the underlying Si (100) substrate surface. Thus, if the aspect ratio of the holes in the patterning mask is greater than 1, threading segments will be blocked by the mask sidewall, resulting in low-defect top Ge "nodules" formed directly on Si. One important limitation of epitaxial necking, however, is the size of the area to which it applies. In general, as discussed in more detail below, the lateral dimensions (designated as I in FIG. 1A) in both dimensions have to be relatively small in order for the dislocations to terminate at sidewalls.

Thus, there is a need in the art for versatile and efficient methods of fabricating semiconductor heterostructures that would constrain dislocation defects in a variety of lattice-mismatched materials systems. There is also a need in the art for semiconductor devices utilizing a combination of integrated lattice-mismatched materials with reduced levels of dislocation defects for improved functionality and performance.

## SUMMARY OF THE INVENTION

Accordingly, it is an object of the present invention to provide semiconductor heterostructures with significantly minimized interface defects, and methods for their fabrication, that overcome the limitations of known techniques. In contrast with the prior art approach of minimizing dislocation defects by limiting misfit epitaxial layers to less than their critical thicknesses for elastic conformation to the substrate, in its various embodiments, the present invention utilizes greater thicknesses and limited lateral areas of component semiconductor layers to produce limited-area regions having upper portions substantially exhausted of threading dislocations and other dislocation defects such as stacking faults, twin boundaries, or anti-phase boundaries. As a result, the invention contemplates fabrication of semiconductor devices based on monolithic lattice-mismatched heterostructures long sought in the art but heretofore impractical due to dislocation defects.

In particular applications, the invention features semiconductor structures of Ge or III-V devices integrated with a Si substrate, such as, for example, an optoelectronic device including a gallium arsenide layer disposed over a silicon wafer, as well as features methods of producing semiconductor structures that contemplate integrating Ge or III-V materials on selected areas on a Si substrate.

In a first aspect of the invention is provided a method of forming a semiconductor heterostructure, the method comprising:

> (a) providing a substrate having a surface and comprising a first semiconductor material;
> (b) providing a dislocation-blocking mask over the substrate, the mask comprising a dielectric material and having a rectangular trench extending to the surface of the substrate and defined by at least one sidewall at least a portion of which meets the surface of the substrate at an orientation angle to a selected crystallographic direction of the first semiconductor material, the trench having a predetermined width W smaller than a length L thereof; and
> (c) depositing in the trench a regrowth layer comprising a second semiconductor material, the orientation angle causing threading dislocations in the regrowth layer to terminate at the sidewall and to decrease in density with increasing distance from the surface of the substrate,

wherein (i) the sidewall of the trench has a height at least equal to a predetermined distance H from the surface of the substrate, (ii) the threading dislocations terminate at the sidewall of the trench in the dislocation-blocking mask at or below the predetermined distance H, and (iii) the sidewall of the trench comprises:

a first portion disposed above the surface of the substrate and having a height at least equal to the predetermined distance H from the surface of the substrate, said first portion of the sidewall being vertical, and

a second portion disposed above the first portion, sloped with respect to the surface of the substrate and flared outwardly.

The method may include providing a substrate that consists essentially of a first semiconductor material, and then providing the dislocation-blocking mask over the substrate. It may be that the orientation angle causes threading dislocations in the regrowth layer to decrease in density with increasing distance from the surface of the substrate. The dislocation-blocking mask includes a dielectric material, such as, for example, silicon dioxide or silicon nitride.

Embodiments of this aspect of the invention include one or more of the following features. An overgrowth layer that includes the second semiconductor material can be deposited over the regrowth layer and over at least a portion of the dislocation-blocking mask. At least a portion of the overgrowth layer can be crystallized. The regrowth layer can be planarized, for example, such that, following the planarizing step, a planarized surface of regrowth layer is substantially co-planar with a top surface of the dislocation-blocking mask. The planarizing step may include chemical-mechanical polishing.

In addition, in various embodiments of the invention, the first semiconductor material is silicon or a silicon germanium alloy. The second semiconductor material can include, or consist essentially of, either a group II, a group III, a group IV, a group V, or a group VI element, or a combination thereof, for example, germanium, silicon germanium, gallium arsenide, aluminum antimonide, indium aluminum antimonide, indium antimonide, indium arsenide, indium phosphide, or gallium nitride. In some embodiments, the second semiconductor material is compositionally graded.

In many embodiments of the invention, the selected crystallographic direction of the first semiconductor material is aligned with at least one direction of propagation of threading dislocations in the regrowth layer. In certain versions of these embodiment, the orientation angle ranges from about 30 to about 60 degrees, for example, is about 45 degrees.

The surface of the substrate may have (100), (110), or (111) crystallographic orientation. In some embodiments, the selected crystallographic direction is substantially aligned with a <110> crystallographic direction of the first semiconductor material. In other embodiments, the portion of the sidewall meets the surface of the substrate in substantial alignment with a <100> crystallographic direction of the first semiconductor material.

In certain embodiments of this and other aspects of the invention, the first semiconductor material is non-polar, the second semiconductor material is polar, and the orientation angle causes anti-phase boundaries in the regrowth layer to decrease in density with increasing distance from the surface of the substrate. Further, in certain embodiments of this and other aspects of the invention, the orientation angle causes stacking faults and/or twin boundaries in the regrowth layer to decrease in density with increasing distance from the surface of the substrate.

The width W of the opening can be less than about 500 nm, and the length L of the opening can exceed each of W and H. In some versions of these embodiments, the substrate consists essentially of silicon and has a (100) crystallographic orientation, the orientation angle is about 45 degrees to the direction of propagation of defects in the regrowth layer, and the predetermined distance H is at least $W\sqrt{2}$. In other versions, the substrate consists essentially of silicon and has a (110) crystallographic orientation, the orientation angle is about 45 degrees, and the predetermined distance H is at least $W\sqrt{6}/3$. In still other versions, the substrate consists essentially of silicon and has a (111) crystallographic orientation, the orientation angle is about 45 degrees, and the predetermined distance H is at least 2W.

In other embodiments of this aspect of the invention, the method additionally includes depositing a lattice-mismatched layer over at least a portion of the substrate prior to providing the dislocation-blocking mask thereon. The lattice-mismatched layer preferably includes a third semiconductor material and is at least partially relaxed. The lattice-mismatched layer can be planarized prior to providing the dislocation-blocking mask. The second semiconductor material and the third semiconductor material can be or include the same semiconductor material.

In a second aspect of the invention is provided a semiconductor structure comprising:

(a) a substrate having a surface and comprising a first semiconductor material;

(b) a dislocation-blocking mask disposed over the substrate, the mask comprising a dielectric material and having a rectangular trench extending to the surface of the substrate, the trench being defined by at least one sidewall at least a portion of which meets the surface of the substrate at an orientation angle to a selected crystallographic direction of the first semiconductor material, the sidewall having a height h at least equal to a predetermined distance H from the surface of the substrate, the trench being rectangular and having a predetermined width W; and

(c) a regrowth layer comprising a second semiconductor material formed in the trench, wherein i) a ratio of the height of the trench to the width of the trench is >0.5; ii) dislocation defects in the regrowth layer terminate at the sidewall of the trench at or below predetermined distance H; and

    (iii) the sidewall of the trench comprises:

        a first portion disposed above the surface of the substrate and having a height at least equal to the predetermined distance H from the surface of the substrate, the first portion of the sidewall being vertical, and a second portion disposed above the first portion, sloped with respect to the surface of the substrate and flared outwardly.

Generally, in yet another aspect, the invention focuses on a semiconductor structure that includes a substrate and a dislocation-blocking mask disposed over the substrate. The substrate may consist essentially of, a first semiconductor material, such as, for example, silicon or a silicon germanium alloy. The dislocation-blocking mask includes a dielectric material, such as, for example, silicon dioxide or silicon nitride. A regrowth layer comprising a second semiconductor material is formed in the opening, such that the orientation angle causes threading dislocations and/or other dislocation defects such as stacking faults, twin boundaries, or anti-phase boundaries in the regrowth layer to decrease in density with increasing distance from the surface of the substrate.

In some embodiments of this aspect of the invention, the selected crystallographic direction of the first semiconductor material is aligned with at least one propagation direction of threading dislocations in the regrowth layer. In certain versions of these embodiments, the orientation angle ranges from about 30 to about 60 degrees, for example, is about 45 degrees.

The surface of the substrate may have (100), (110), or (111) crystallographic orientation. In some embodiments, the selected crystallographic direction is substantially aligned with a <110> crystallographic direction of the first semiconductor material. In other embodiments, the portion of the sidewall meets the surface of the substrate in substantial alignment with a <100> crystallographic direction of the first semiconductor material.

Also, certain embodiments of this aspect of the invention include an overgrowth layer disposed over the regrowth layer and over at least a portion of the dislocation-blocking mask, as well as a lattice-mismatched layer disposed over at least a portion of the substrate underneath the dislocation-blocking mask. The overgrowth layer and/or the lattice-mismatched layer may include a second semiconductor material and may be at least partially relaxed.

In a third aspect of the invention is provided a semiconductor device comprising a structure of the second aspect, the regrowth region of the structure including:

    i. a first portion formed in the opening comprising a second semiconductor material and disposed above the surface of the substrate, dislocation defects in the regrowth region terminating in the first portion; and
    ii. a second portion disposed above the first portion, the second portion comprising a third semiconductor material;

the device also comprising:

    (a) a channel region disposed in the second portion of the regrowth region; and
    (b) a source region and a drain region, the channel region being disposed therebetween.

The substrate may consist essentially of, a first semiconductor material, for example, a silicon. The orientation angle to a selected crystallographic direction of the first semiconductor material may be, for example, about 45 degrees to the direction of propagation of threading dislocations in the regrowth region. The regrowth region may have a first portion disposed proximal to the surface of the substrate, where threading dislocations and/or other dislocation defects such as stacking faults, twin boundaries, or anti-phase boundaries in the regrowth region substantially terminate, and a second portion disposed above the first portion and having the channel region formed therein. The first portion of the regrowth region may include a second semiconductor material and the second portion may include a third semiconductor material. The second and third semiconductor materials may be, or include, the same material.

In one embodiment, the semiconductor substrate includes a silicon wafer, an insulating layer disposed thereon, and a strained semiconductor layer disposed on the insulating layer. The strained semiconductor layer may include silicon or germanium. As used herein, the term "strain" encompasses uniaxial and biaxial strain, as well as tensile and compressive strain. In another embodiment, the semiconductor substrate includes a silicon wafer, a compositionally uniform relaxed $Si_{1-x}Ge_x$ layer (where $0 < x < 1$) deposited thereon, a strained silicon layer deposited on the relaxed $Si_{1-x}Ge_x$ layer. A compositionally graded $Si_{1-x}Ge_x$ layer can be disposed between the compositionally uniform $Si_{1-x}Ge_x$ relaxed layer and the silicon wafer. Also, an insulating layer can be disposed between the compositionally uniform relaxed $Si_{1-x}Ge_x$ layer and the silicon wafer. In yet another embodiment, at least partially relaxed lattice-mismatched layer is disposed between at least a portion of the substrate and the dislocation-blocking mask.

The second semiconductor material and/or the third semiconductor material can include, or consist essentially of, a group II, a group III, a group IV, a group V, and/or a group VI element, and/or combinations thereof, for example, germanium, silicon germanium, gallium arsenide, gallium nitride, indium aluminum arsenide, indium gallium arsenide, indium gallium phosphide, aluminum antimonide, indium aluminum antimonide, indium antimonide, and/or indium phosphide. In some embodiments, the first portion of the regrowth region may include silicon germanium and the second portion of the regrowth region may include a layer of strained germanium or strained silicon germanium. In other embodiments, the first portion of the regrowth region includes indium phosphide and the second portion of the regrowth region includes a layer of indium gallium arsenide disposed over a layer of indium aluminum arsenide. In other embodiments, the first portion of the regrowth region may include indium aluminum antimonide and the second portion of the regrowth region may include a layer of indium antimonide.

In various embodiments of the invention, the selected crystallographic direction of the first semiconductor material is aligned with at least one propagation direction of threading dislocations in the regrowth region. The dislocation-blocking mask includes a dielectric material which may be, for example, silicon dioxide or silicon nitride. In a particular embodiment, the dislocation-blocking mask includes a silicon nitride layer disposed over a silicon dioxide layer.

In certain embodiments, the source region and the drain region of the device are epitaxially deposited over the dislocation-blocking mask; for example, they may represent a structure epitaxially deposited over the dislocation-blocking mask proximal to the regrowth region following formation thereof. In some versions of these embodiments, the structure includes a first material forming a Schottky junction at the interface with the regrowth region. The structure may further include a second material, which may be strained, unstrained, or amorphous. A gate insulator can be disposed over the regrowth region, and, in some embodiments, a silicon layer having thickness ranging from about 5 Å to about 15 Å is disposed between the gate insulator and the regrowth region.

In another aspect of the disclosure is featured an integrated circuit that includes a substrate and a dislocation-blocking mask disposed over the substrate. The mask has an opening extending to the surface of the substrate and defined by at least one sidewall. The substrate includes, or consists essentially of, a first semiconductor material, such as, for example, silicon. At least a portion of the sidewall meets the surface of the substrate at an orientation angle to a selected crystallographic direction of the first semiconductor material. The integrated circuit also includes a regrowth region formed in the opening. The regrowth region has a first portion disposed proximal to the surface of the substrate, and threading dislocations and/or other dislocation defects such as stacking faults, twin boundaries, or antiphase boundaries in the regrowth region substantially terminate in the first portion. The regrowth layer also has a second portion disposed above the first portion. The first and second portions include, or consist essentially of, either different or the same semiconductor material(s). Further, a p-transistor is formed over a first area of the semiconductor substrate and an n-transistor is formed over a second area of the semiconductor substrate, each transistor has a channel through the second portion of the regrowth region. The transistors are interconnected in a CMOS circuit.

In yet another aspect, the disclosure relates to a method of forming a nonplanar FET. The method begins with providing a substrate that includes, or consists essentially of, a first semiconductor material, such as, for example, silicon. The method further includes the steps of providing a dislocation-blocking mask over the substrate and forming an opening in the mask extending to the surface of the substrate and defined by at least one sidewall. The mask has a first dielectric layer disposed over a second dielectric layer. At least a portion of the sidewall meets the surface of the substrate at an orientation angle to a selected crystallographic direction of the first semiconductor material. The method additionally includes selectively forming in the opening a regrowth region that contains a second semiconductor material. The orientation angle and/or the image force causes threading dislocations and/or other dislocation defects such as stacking faults, twin boundaries, or antiphase boundaries in the regrowth region to decrease in density with increasing distance from the surface of the substrate. The method further includes selectively removing at least a portion of the first dielectric layer to expose at least a portion of the regrowth region, thereby forming a semiconductor fin structure. A gate dielectric region is provided over at least a portion of the fin structure. A gate contact is disposed over the gate dielectric region. A source region and a drain region can be formed in the fin structure. The regrowth region can be planarized, for example, by chemical-mechanical polishing, prior to selectively removing at least a portion of the first dielectric layer.

Also, in a further aspect, the disclosure contemplates a method of forming an optoelectronic device. The method begins with providing a substrate that includes, or consists essentially of, a first semiconductor material, such as, for example, silicon. The method further includes the steps of providing a dislocation-blocking mask over the substrate and forming an opening in the mask extending to the surface of the substrate. The opening is defined by at least one sidewall. At least a portion of the sidewall meets the surface of the substrate at an orientation angle to a selected crystallographic direction of the first semiconductor material. The method additionally includes selectively depositing in the opening a first portion of the regrowth region that contains, or consists essentially of, a second semiconductor material, while in situ doping the second semiconductor material until thickness of the first portion approximates or exceeds the predetermined distance. The orientation angle causes threading dislocations and/or other dislocation defects such as stacking faults, twin boundaries, or anti-phase boundaries in the first portion to substantially terminate at or below a predetermined distance from the surface of the substrate. The method continues with the step of selectively depositing a second portion of the regrowth region that contains, or consists essentially of, a third semiconductor material, in the opening to a thickness selected to achieve a predetermined level of absorption of incident light; and then forming a doped region in the second portion. In various embodiments, the method further includes, prior to providing a dislocation-blocking mask, the step of forming a p-type or n-type region in the substrate.

## BRIEF DESCRIPTION OF THE DRAWINGS

In the drawings, like reference characters generally refer to the same parts throughout the different views. Also, the drawings are not necessarily to scale, emphasis instead generally being placed upon illustrating the principles of the invention. In the following description, various embodiments of the present invention are described with reference to the following drawings, in which:

FIG. 1A depicts a schematic cross-sectional side view of a silicon substrate with a germanium layer formed thereon according to an "epitaxial necking" technique known in the art;
FIG. 1B is an XTEM image illustrating the semiconductor heterostructure of FIG. 1A;
FIGS. 2A-2C are schematic diagrams showing the three types of crystalline orientation for silicon;
FIGS. 3A -3B, 4A -4E, and 5A-5B depict schematic views of different lattice-mismatched semiconductor heterostructures and structures for blocking dislocations therein,
FIGS. 6A-6H and 7A-7C depict schematic cross-sectional side views of the lattice-mismatched semiconductor heterostructures having increased active area,
FIGS. 8-10 depict various applications of dislocation blocking techniques for semiconductor devices,
FIGS. 11-12 depict Ge or III-V photodetector integration into Si substrate ; and
FIGS. 13A-13C depict semiconductor heterostructures employing dislocation-blocking techniques.

## DETAILED DESCRIPTION

In accordance with its various embodiments, the present invention contemplates fabrication of monolithic lattice-mismatched semiconductor heterostructures with limited area regions having upper surfaces substantially exhausted of threading dislocations and other dislocation defects, as well as fabrication of semiconductor devices based on such lattice-mismatched heterostructures.

Silicon (Si) is recognized as presently being the most ubiquitous semiconductor for the electronics industry. Most of silicon that is used to form silicon wafers is formed from single crystal silicon. The silicon wafers serve as the substrate on which CMOS devices are formed. The silicon wafers are also referred to as a semiconductor substrate or a semiconductor wafer. While described in connection with silicon substrates, however, the use of substrates that include, or consist essentially of, other semiconductor materials, is contemplated without departing from the spirit and scope of the present invention.

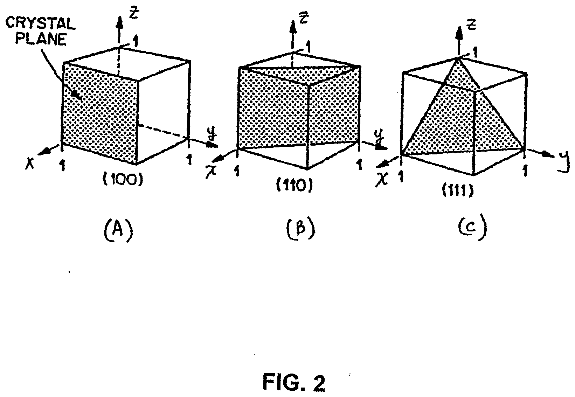

In crystalline silicon, the atoms which make up the solid are arranged in a periodic fashion. If the periodic arrangement exists throughout the entire solid, the substance is defined as being formed of a single crystal. If the solid is composed of a myriad of single crystal regions the solid is referred to as polycrystalline material. As readily understood by skilled artisans, periodic arrangement of atoms in a crystal is called the lattice. The crystal lattice also contains a volume which is representative of the entire lattice and is referred to as a unit cell that is regularly repeated throughout the crystal. For example, silicon has a diamond cubic lattice structure, which can be represented as two interpenetrating face-centered cubic lattices. Thus, the simplicity of analyzing and visualizing cubic lattices can be extended to characterization of silicon crystals. In the description herein, references to various planes in silicon crystals will be made, especially to the (100), (110), and (111) planes. These planes define the orientation of the plane of silicon atoms relative to the principle crystalline axes. The numbers {xyz} are referred to as Miller indices and are determined from the reciprocals of the points at which the crystal plane of silicon intersects the principle crystalline axes. Thus, **FIGS. 2A-2C** show three orientations of the crystal plane of silicon. In **FIG. 2A,** the crystal plane of silicon intersects the x-axis at 1 and never intersects the y or z-axis. Therefore, the orientation of this type of crystalline silicon is (100). Similarly, **FIG. 2B** shows (110) crystalline silicon and **FIG. 2C** shows (111) silicon. The (111) and (100) orientations are the two primary wafer orientations in commercial use. Notably, for any given plane in a cubic crystal there are five other equivalent planes. Thus, the six sides of the cube comprising the basic unit cell of the crystal are all considered (100) planes. The notation {xyz} refers to all six of the equivalent (xyz) planes. Throughout the description, reference will also be made to the crystal directions, especially the <100>, <110> and <111> directions. These are defined as the normal direction to the respective plane. Thus, the <100> direction is the direction normal to the (100) plane. The notation <xyz> refers to all six equivalent directions.

As discussed above, there is a need in the art for versatile and efficient methods of fabricating semiconductor heterostructures that would constrain substrate interface defects in a variety of lattice-mismatched materials systems. One conventional technique mentioned above that addresses control of threading dislocation densities in highly-mismatched deposited layers, termed "epitaxial necking," is applicable only to devices with relatively small lateral dimensions. Specifically, in the prior art, metal oxide semiconductor ("MOS") transistors are typically fabricated on (100) silicon wafers with the gates oriented such that current flows parallel to the <110> directions. Thus, for a FET device built on a (100) Si wafer with device channel orientation aligning with the <110> direction, both the channel width and channel length should be small compared to the height of a epitaxial necking mask, in order for the dislocations in a lattice-mismatched semiconductor layer to terminate at a sidewall of the mask on both directions. However, in modern CMOS circuits, the MOSFET device width often substantially exceeds the channel length, which, as a result of CMOS scaling, is frequently very small. Accordingly, under the conventional necking approach, a number of dislocations will not be terminated at the sidewall of the mask in the direction of the channel width.

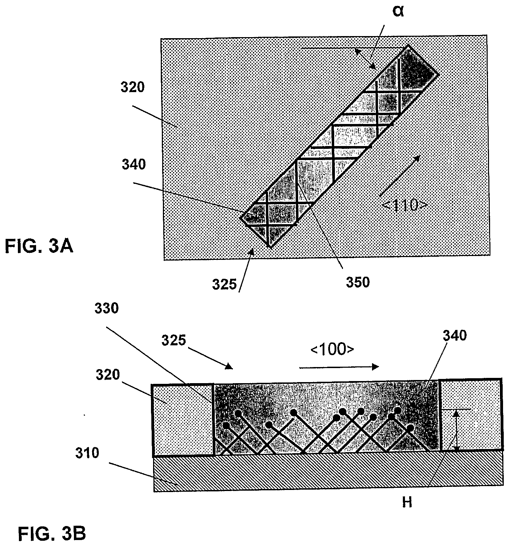

In contrast with the prior art approach of minimizing dislocation defects, in its various embodiments, the present invention addresses the limitations of known techniques, by utilizing greater thicknesses and limited lateral areas of component semiconductor layers to produce limited-area regions having upper portions substantially exhausted of dislocation defects. Referring to FIGS. 3A-3B, a substrate 310 is provided that includes, or consists essentially of, a first semiconductor material, such as, for example, silicon. A dislocation-blocking mask 320 is disposed over the substrate. The mask has an opening 325 extending to the surface of the substrate and defined by at least one sidewall 330. The opening 325 is generally rectangular. The dislocation-blocking mask includes a dielectric material, such as, for example, silicon dioxide or silicon nitride. At least

a portion of the sidewall meets the surface of the substrate at an orientation angle α to a selected crystallographic direction of the first semiconductor material. In addition, at least a portion of the sidewall is generally vertical, i.e. disposed at about 80 to 120 degrees to the surface of the substrate, and, in a particular embodiment, substantially perpendicular to the surface of the substrate.

A regrowth layer **340** that includes a second semiconductor material is deposited in the opening. In one embodiment, the selected crystallographic direction of the first semiconductor material is aligned with direction of propagation of threading dislocations in the regrowth layer. In certain embodiments, the orientation angle ranges from about 30 to about 60 degrees, for example, is about 45 degrees to such crystallographic direction. The surface of the substrate may have (100), (110), or (111) crystallographic orientation. In some embodiments, the selected crystallographic direction is substantially aligned with a <110> crystallographic direction of the first semiconductor material.

In various embodiments, the first semiconductor material may include, or consist essentially of, silicon or a silicon germanium alloy. The second semiconductor material may include, or consist essentially of, a group II, a group III, a group IV, a group V, and/or a group VI element, and/or combinations thereof, for example, selected from the group consisting of germanium, silicon germanium, gallium arsenide, aluminum antimonide, indium aluminum antimonide, indium antimonide, indium arsenide, indium phosphide, and gallium nitride.

The regrowth layer can be formed in the opening by selective epitaxial growth in any suitable epitaxial deposition system, including, but not limited to, atmospheric-pressure CVD (APCVD), low- (or reduced-) pressure CVD (LPCVD), ultra-high-vacuum CVD (UHVCVD), by molecular beam epitaxy (MBE), or by atomic layer deposition (ALD). In the CVD process, selective epitaxial growth typically includes introducing a source gas into the chamber. The source gas may include at least one precursor gas and a carrier gas, such as, for example hydrogen. The reactor chamber is heated, such as, for example, by RF-heating. The growth temperature in the chamber ranges from about 300°C to about 900°C depending on the composition of the regrowth layer. The growth system also may utilize low-energy plasma to enhance the layer growth kinetics.

The epitaxial growth system may be a single-wafer or multiple-wafer batch reactor. Suitable CVD systems commonly used for volume epitaxy in manufacturing applications include, for example, EPI CENTURA single-wafer multi-chamber systems available from Applied Materials of Santa Clara, CA, or EPSILON single-wafer epitaxial reactors available from ASM International based in Bilthoven, The Netherlands.

In some embodiments, the regrowth layer is compositionally graded, for example, includes Si and Ge with a grading rate in the range of >5% Ge/$\mu$m to 100% Ge/$\mu$m, preferably between 5% Ge/$\mu$m and 50% Ge/$\mu$m, to a final Ge content of between about 10% to about 100%. While the overall grading rate of the graded layer is generally defined as the ratio of total change in Ge content to the total thickness of the layer, a "local grading rate" within a portion of the graded layer may be different from the overall grading rate. For example, a graded layer including a 1 $\mu$m region graded from 0% Ge to 10% Ge (a local grading rate of 10% Ge/$\mu$m) and a 1 $\mu$m region graded from 10% Ge to 30% Ge (a local grading rate of 20% Ge/$\mu$m) will have an overall grading rate of 15% Ge/$\mu$m. Thus, the regrowth layer may not necessarily have a linear profile, but may comprise smaller regions having different local grading rates. In various embodiments, the graded regrowth layer is grown, for example, at 600 - 1200 0C. Higher growth temperatures, for example, exceeding 900°C may be preferred to enable faster growth rates while minimizing the nucleation of threading dislocations. See, generally, U.S. Patent No. 5,221,413.

In a particular embodiment, the first semiconductor material is silicon and the second semiconductor material is germanium. In this embodiment, threading dislocations 350 in the regrowth layer propagate along a <110> direction, and lie at an angle of 45-degrees to the surface of the first semiconductor material. The dislocation mask having a generally rectangular opening is disposed over the substrate such that the sidewall of the opening is disposed at a 45-degree angle to a <100> direction and is substantially aligned with a <110> crystallographic direction. As a result of such orientation of the opening, dislocations will reach and terminate at the sidewalls of the opening in the dislocation-blocking mask at or below a predetermined distance H from the surface of the substrate, such that threading dislocations in the regrowth layer decrease in density with increasing distance from the surface of the substrate. Accordingly, the upper portion of the regrowth layer is substantially exhausted of threading dislocations, enabling formation of semiconductor devices having increased channel width.

The sidewall of the opening in the dislocation-blocking mask has a height at least equal to a predetermined distance H from the surface of the substrate. The opening is substantially rectangular and has a predetermined width W that is smaller than a length L of the opening. For example, the width W of the opening can be less than about 500 nm, and the length L of the opening can exceed each of W and H. In some versions of these embodiments, the substrate consists essentially of silicon and has a (100) crystallographic orientation, the orientation angle is about 45 degrees to propagation of dislocations in the regrowth layer, and the predetermined distance H is at least $W\sqrt{2}$. In other versions, the substrate consists essentially of silicon and has a (110) crystallographic orientation, the orientation angle is about 45 degrees, and the predetermined distance H is at least $W\sqrt{6}/3$. In still other versions, the substrate consists essentially of silicon and has a (111) crystallographic orientation, the orientation angle is about 45 degrees, and the predetermined distance H is at least 2W.

In various embodiments of the invention, blocking of the dislocations is promoted both by geometry and orientation of the mask discussed above as well as because of the 'image force' whereby dislocations are attracted to substantially vertical surfaces, as explained in more detail below. In many embodiments, the image force alone is sufficient to cause the upper portion of the regrowth layer to be substantially exhausted of threading dislocations and other dislocation defects.

As skilled artisans will readily recognize, a dislocation near a surface experiences forces generally not encountered in the bulk of a crystal, and, in particular, is attracted towards a free surface because the material is effectively more compliant there and the dislocation energy is lower. See Hull & Bacon, Introduction to Dislocations, 4th edition, Steel Times (2001). Image force is determined by material properties of the semiconductor being grown, as well as the distance between a given dislocation and the free surface. Thus, even when the dislocations have an orientation that does not favor trapping at sidewalls, the approach discussed above is still effective at certain dimensions because of the boundary forces that draw dislocations to free surfaces in order to reduce the elastic energy of the crystal. Mathematically, these forces arise because the boundary conditions of the expressions for strain require strain components normal to a surface to be zero at that surface. Thus, force per unit of dislocation length on an edge dislocation, toward a vertical sidewall can be represented by the formula:

$$F_I = \frac{Gb^2}{4\pi d\,(1-\nu)}$$

where

$F_1$ = Image force
G = Shear modulus
d = distance from free surface
b = Burgers vector
$\nu$ = Poisson's ratio

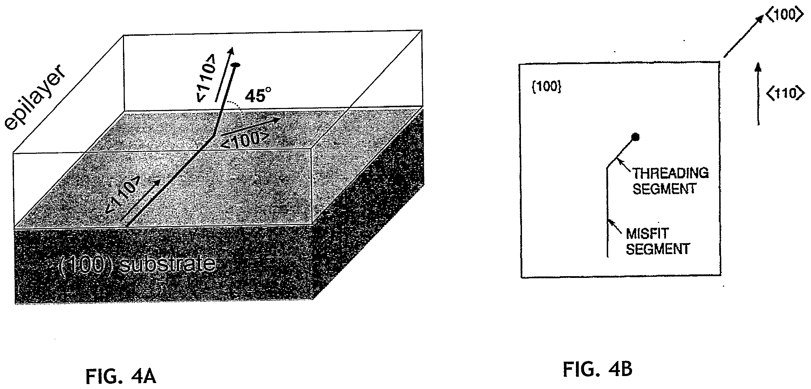

Referring to **FIGS. 4A-4B,** as used herein, the term "60° dislocation" refers to a dislocation for which the angle between the Burgers vector and the dislocation line is 60°. These dislocations typically form in diamond-cubic or zincblende lattice-mismatched systems where the strain is relatively low (e.g. < 2%). In the absence of forces on threads (which can come from other dislocations nearby or from a free surface nearby) they rise from the substrate surface at a 45° angle in <110> directions. However, when viewed from above (normal to the surface) they appear to lie in <100> directions.

Experimentally, it has been shown that for the case of germanium on silicon (4% mismatch) dislocations within approximately 300nm of a $SiO_2$ sidewall are trapped. This is understood to be due to the influence of the image force. The angle between these dislocations and the sidewall appears to range between approximately 45-55°.

The relevant material constants for Ge are:

G = 4.1e11 dyne/cm$^2$
$\nu$ = 0.26; and
b = 3.99 Å

Based on the above formula and the experimental observation that for d ≤ 300nm dislocations in Ge on Si are bent toward an $SiO_2$ sidewall, the force necessary to bend a dislocation in a cubic semiconductor crystal toward a free surface is approximately 2.3 dyne/cm. Thus, distance from free surface d for other materials can be estimated with certain degree of accuracy based on their known values for G, v, and b. For example, by these calculations:

For GaAs **d** = 258 nm
For InP **d** = 205 nm
For AlSb **d** = 210 nm

For InSb **d** = 164 nm

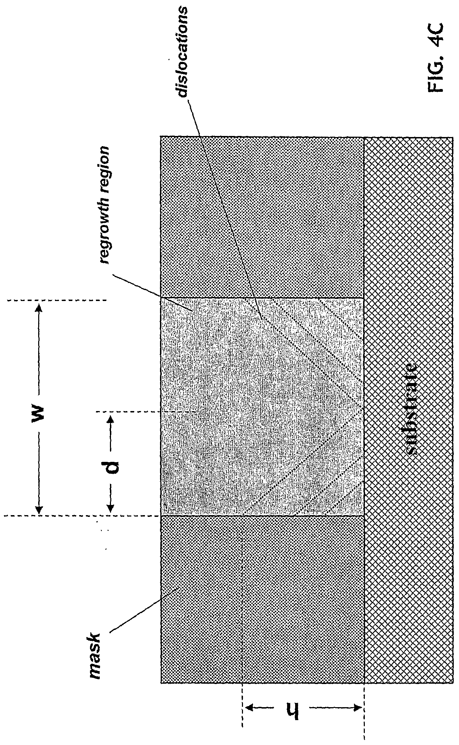

Referring to **FIG. 4C,** for full trapping, the hole or trench lateral dimension w is preferably less than or equal to approximately **2\*d,** while the vertical dimension h is preferably at least approximately **d,** where d is calculated discussed above. These criteria are expected to be substantially independent of the orientation of the boundary of the sidewall and the substrate surface. Thus, dislocations in the lower portion of the regrowth layer are trapped by employing a dislocation-blocking mask with an elongated opening, e.g. a trench, having a width calculated as discussed above and oriented without any regard for the direction of propagation of dislocations in the regrowth layer.

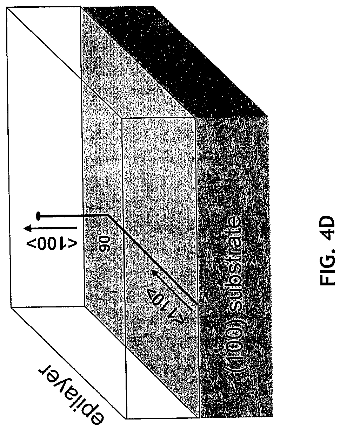

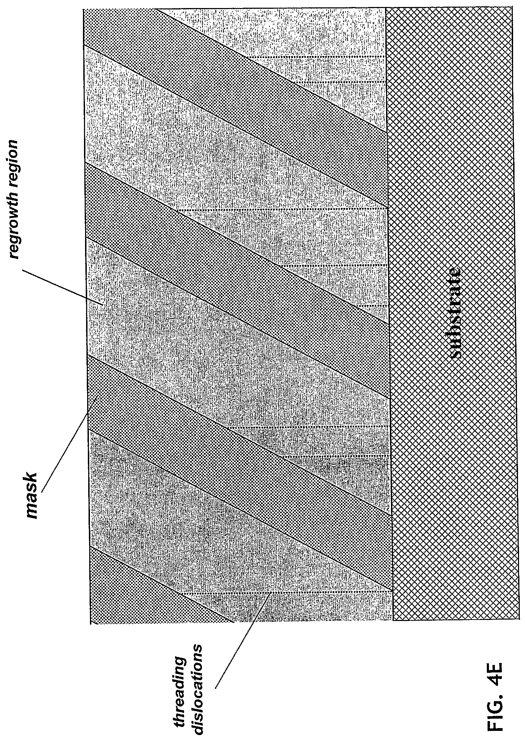

Further, as shown in **FIG. 4D** and used herein, the term "90° dislocation" refers to a dislocation for which the angle between the Burgers vector and the dislocation line is 90°. These dislocations primarily form in mismatched systems where the strain is relatively high (e.g. > 2%). In the absence of forces on threading dislocation (which can come from other dislocations nearby or from a free surface nearby) they rise from the substrate surface at a 90° angle in <100> directions. Thus, these dislocations can be trapped most optimally by using a dislocation-blocking mask with slanted, rather than vertical sidewalls, as shown in **FIG. 4E.**

The following summarizes mechanisms for trapping dislocations in different kind of diamond-cubic or zincblende semiconductor heterostructures:

    1. Low mismatch, low image force

- 60° dislocations predominate
- Threads lie in <110> directions, rising from surface at 45°
- Best approach for trapping dislocations is to rely on appropriate orientation of sidewalls and appropriate dimensioning of openings, as described above in connection with **FIGS. 3A-3B;**

    2. Low mismatch, high image force

- 60° dislocations predominate
- Threads bend toward free substantially vertical surfaces
- Best approach for trapping dislocations is described above in connection with **FIGS. 4A-4C;**

    3. High mismatch, high image force

- 90° dislocations predominate
- Threads bend toward free substantially vertical surfaces
- Best approach for trapping dislocations is described above in connection with **FIGS. 4A-4C;** and

    4. High mismatch, low image force

- 90° dislocations predominate
- Threads lie in <100> directions, rising from surface at 90°
- Best approach for trapping dislocations is described above in connection with **FIGS. 4D-4E**

Hexagonal semiconductors, such as the III-nitride (III-N) materials, are of great interest for high-power high-speed electronics and light-emitting applications. For epitaxy of hexagonal semiconductors such as III-nitrides on Si, the (111) surface of Si is commonly preferred over the (100). This is because the (111) surface of Si is hexagonal (even though Si is a cubic crystal). This makes a better template for hexagonal crystal growth than the cubic (100) face. However, as mentioned above, epitaxial necking approach discussed above is less effective in these applications, because the threading dislocations in the hexagonal semiconductors disposed over the lattice-mismatched Si (111) substrates may not be effectively confined by the vertical sidewalls because the threading dislocations in such materials typically have a different orientation relative to the substrate, compared to the more commonly used cubic semiconductors, such as Si, Ge, and GaAs. For example, as described above in connection with **FIG. 4E,** for certain surface orientations of substrate and crystalline structure of lattice-mismatched regrowth region, the threading defects tend to propagate perpendicular to the substrate, which may not favor trapping by vertical sidewalls of the dislocation-blocking mask. This is the case when GaN is grown on the (100) surface of Si. In such a case, the angle of the sidewalls of the opening can be slanted relative to the substrate, as shown in **FIG. 4E** such that vertically propagating defects intersect the angled sidewalls.

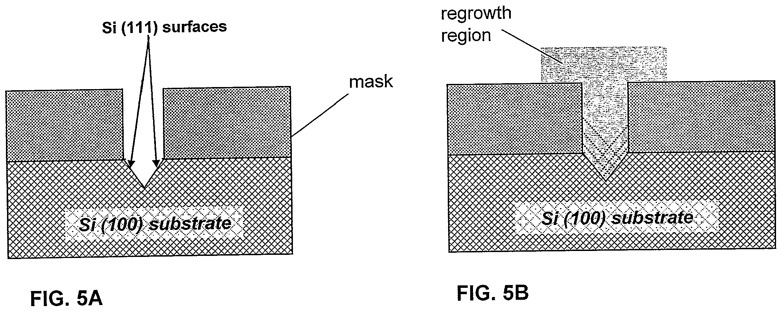

The surface of the underlying substrate itself exposed in the opening may be configured to enable confinement of the threading dislocations. Referring to FIG. 5A, after the dislocation-blocking mask is disposed over the Si (100) substrate and an opening is defined therethrough, an etch that is selective to the (111) crystallographic plane of Si, for example, a KOH solution, is applied to the portion of the substrate exposed at the bottom of the seed window to expose (111) surfaces. A lattice-mismatched semiconductor material is then deposited in the opening over the substrate, and the epitaxial deposition continues such that a heteroepitaxial region is grown over the material disposed in the opening, laterally expanding over the mask. Because of the configuration of the underlying surface, orientation of the threading dislocations in the heteroepitaxial region is at approximately 45° to the surface of the substrate, facilitating trapping of the dislocation by substantially vertical sidewalls of the mask, as shown in **FIG. 5B.** Then, if small areas of hexagonal semiconductor material are desired for device active areas, the heteroepitaxial overgrowth regions expanding from the individual openings can be planarized (e.g. via CMP), to be substantially co-planar with the adjacent insulator areas. Alternatively, if a large area is desired, growth can proceed until neighboring regions coalesce, followed optionally by planarization of the resulting structure. In the latter case, because lateral growth rates of hexagonal semiconductor can be dramatically increased over growth rate normal to the surface employing various known approaches, these semiconductor materials afford process flexibility not available with cubic semiconductors grown on (100) surfaces. Specifically, differential growth rates of these materials allows for widely-spaced seed trenches; for example, spacing may be five times trench width or even greater, offering a substantial advantage over closely-spaced seed trenches, if the defects which are known to form when epitaxial growth fronts coalesce cannot be substantially eliminated.

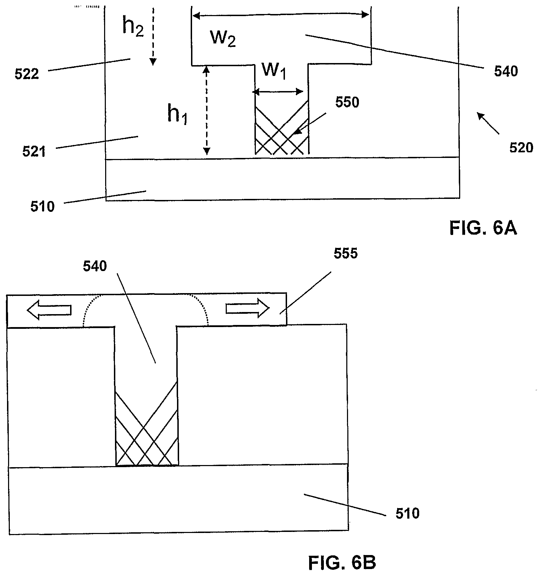

FIGS. 6A-6F depict schematic cross-sectional side views of the lattice-mismatched semiconductor heterostructures having increased surface area. Specifically, as discussed in more detail below, the area of the upper portion of the lattice-mismatched heterostructure substantially exhausted of threading dislocations is increased, compared to the embodiments described above with reference to FIGS. 3A-3B. For example, as described in more detail below, in some embodiments, the opening in the dislocation-blocking mask has a variable width. The sidewall of the opening in the dislocation-blocking mask includes a first portion disposed proximal to the surface of the substrate, and a second portion disposed above the first portion. A height of the first portion is at least equal to a predetermined distance H from the surface of the substrate, where the threading dislocations terminate at the sidewall of the opening in the dislocation-blocking mask at or below the distance H. The second portion of the sidewall is flared outwardly.

In many of the embodiments described below, a substrate 510 includes, or consists essentially of, silicon. The regrowth layer includes, or consists essentially of, a semiconductor material that is one of a group II, a group III, a group IV, a group V, and/or a group VI elements, and/or combinations thereof, for example, selected from the group consisting of germanium, silicon germanium, gallium arsenide, aluminum antimonide, indium aluminum antimonide, indium antimonide, indium arsenide, indium phosphide and gallium nitride. A dislocation-blocking mask 520 having an opening therein is disposed over the substrate. The dislocation-blocking mask may include a dielectric material, such as, for example, silicon dioxide or silicon nitride. At least a portion of the sidewall meets the surface of the substrate at an orientation angle $\alpha$ to a selected crystallographic direction of the first semiconductor material. A regrowth layer 540 that includes a second semiconductor material is deposited in the opening. In various embodiments, the selected crystallographic direction of the first semiconductor material is aligned with direction of propagation of threading dislocations in the regrowth layer. In various embodiments, the orientation angle ranges from about 30 to about 60 degrees, for example, is about 45 degrees. As mentioned above, in many embodiments of the invention, blocking of the dislocations is promoted by geometry and orientation of the mask discussed above and/or the 'image force.'

Referring to FIG. 6A, the dislocation-blocking mask is formed by depositing a first low-temperature oxide layer 521 having thickness h1 over the substrate. The thickness h1 is selected to be at least equal to the distance from the surface of the substrate at which the threading dislocations (and/or other dislocation defects such as stacking faults, twin boundaries, or anti-phase boundaries) terminate at the sidewall of the opening in the dislocation-blocking mask, as discussed above. A first aperture having a diameter d1 or a first trench having a width w1, both the width w1 and diameter d1 being smaller than the thickness h1, are formed in the layer 521 by a conventional masking/etching technique. After the mask is stripped, a second low-temperature oxide layer 522 having a thickness h2 is deposited over the layer 521. Then, a second aperture of diameter d2 or a second trench having a width w2 is formed in the layer 522 by a conventional masking/etching technique, such that w1 < w2 (or d1 < d2). After the mask is stripped, the regrowth layer of second semiconductor material is deposited in the first and second apertures or in first and second trenches by selective epitaxy, according to any of the techniques disclosed in U.S. Patent Application Publication No. 2004/0045499A by Langdo et al. As discussed above, following deposition, threading dislocations and/or other dislocation defects substantially terminate in the first aperture (or in the first trench) at or below thickness h1. As a result, the regrowth layer portion having thickness h2 that is substantially exhausted of threading dislocations is obtained with an upper surface that is larger compared to the embodiments described above with reference to FIGS. 3A-3B.

Referring to FIG. 6B, an overgrowth layer 555 that includes the second semiconductor material is deposited over the regrowth layer 540 and over a portion of the dislocation-blocking mask 520 adjacent to the regrowth layer. At least a portion of the overgrowth layer may be deposited as non-crystalline (i.e. amorphous) material and can be crystallized subsequently, for example by an anneal step at a temperature higher than the deposition temperature. Thus, crystallization of the overlayer is used to create crystal material in the overlayer regions over the regrowth layer, which is amorphous upon deposition. The arrows in FIG. 6B indicate a crystallized region expanding outward from the opening in the dislocation blocking mask, as amorphous material which may form at least a portion of the overgrowth layer 555 is crystallized.

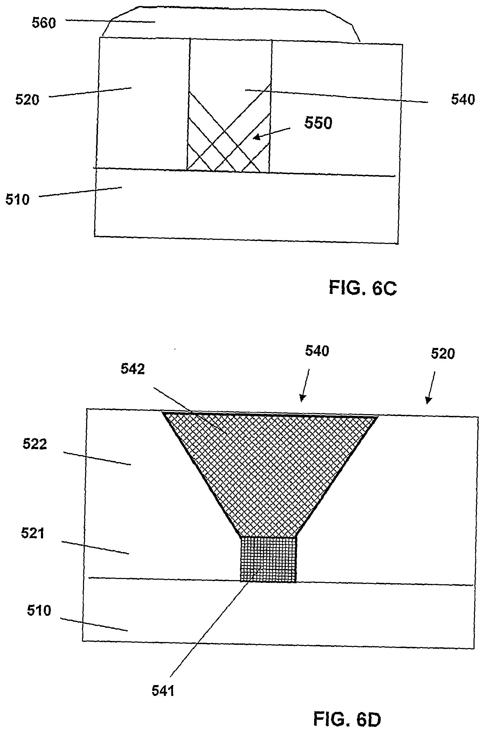

Referring to FIG. 6C, deposition of the regrowth layer in the opening of the dislocation-blocking mask is followed by a step of lateral epitaxial deposition to increase the useful surface area. It may also utilize the higher growth rates typical of (100) surfaces compared to (110) or (111) surface to increase lateral overgrowth. For example, the overgrowth regions can be used as source/drain areas which typically have less stringent material quality requirement than the channel material.

Referring to FIG. 6D, the useful upper area of the regrowth layer 540 is increased by gradually increasing the size of the regrowth region. Similar to FIG. 6A, the dislocation-blocking mask includes two layers - a first layer having thickness h1, and a second layer having thickness h2. The thickness h1 is selected to be at least equal to the distance from the surface of the substrate at which the threading dislocations and/or other dislocation defects terminate at the sidewall of the opening in the dislocation-blocking mask, as discussed above. That is, a first aperture having a diameter d1 or a first trench having a width w1, both the width w1 and diameter d1 being smaller than the thickness h1, are formed in the layer 521 by a conventional masking/etching technique. After the mask is stripped, a second low temperature oxide layer 522 having a thickness h2 is deposited over the layer 521. Then, a second aperture of diameter d2 or a second trench having a width w2 is formed in the layer 522 by a conventional masking/etching technique, such that w1 < w2 (or d1 < d2). In contrast to FIG. 6A, however, the width w2 of the second trench is gradually increased such that the sidewall of the trench, i.e. the opening in the layer 522, gradually flares outwardly. This effect can be achieved, for example, by conventional masking/etching techniques wherein the etchant and masking material are chosen such that the masking material is eroded laterally during the etching process, gradually exposing more of the dislocation-blocking mask below, resulting in an opening in the dislocation-blocking mask that flares outward. For example, the masking material could be conventional photoresist and the etchant could be a mixture of the gases $CF_4$ and $H_2$, used in a conventional RIE system. After the mask is stripped, the regrowth layer of second semiconductor material is deposited by selective epitaxy in the opening defined by the layers 521, 522. As discussed above, following deposition, threading dislocations (and/or other dislocation defects such as stacking faults, twin boundaries, or antiphase boundaries) substantially terminate in the first aperture (or in the first trench) at or below thickness h1. Thus, the dislocations are terminated in the first portion of the regrowth region at or below thickness h1, and then the regrowth layer becomes larger and larger gradually, allowing for high-quality epitaxial growth with large surface area for large device fabrication.

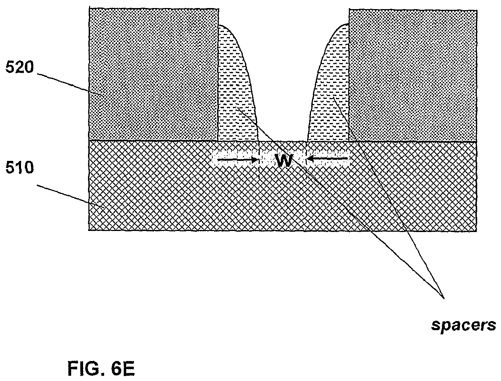

Referring to FIG. 6E, in an alternative version of FIG. 6D, a dislocation-blocking mask having an opening with outward slanted sidewalls, i.e. the structure that is substantially narrower at the bottom than the top, can be formed with only one lithography step, followed by spacer deposition and etch. This technique is generally more economical and may overcome lithographic alignment problems, or lithographic minimum feature limitations, inherent with the lithography-and-etch approach. The spacers can be formed from the same or different material than the insulator layer. For either case, selective epitaxial growth follows creation of the opening or trench.

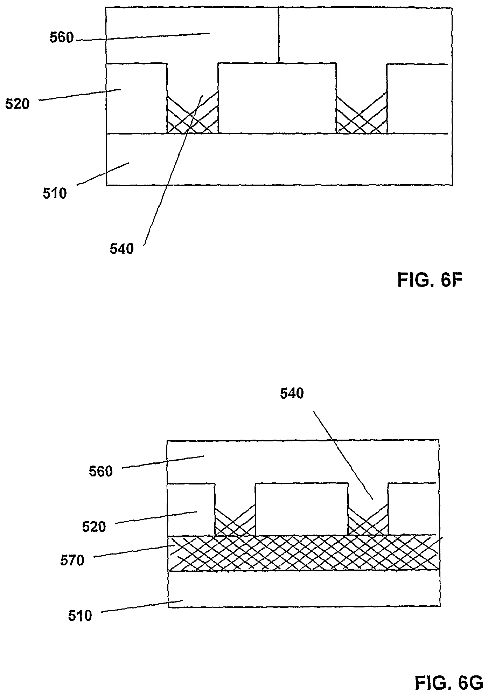

FIGS. 6F-6H show further techniques to increase the surface area. Referring to FIG. 6F (as well as, again, to FIG. 6B) silicon nitride is utilized instead of silicon dioxide as a dielectric material for the dislocation-blocking mask 520 that defines two openings 535. After the regrowth regions 540 are epitaxially grown in the openings, overgrowth regions 560 are deposited thereover. Using silicon nitride facilitates merging two overgrown regions on the surface of dislocation-blocking mask 520 layer with fewer defects, resulting in larger surface area. Referring to FIG. 6G, in one particular version of FIG. 6F, a layer of second semiconductor material 570 is deposited over the substrate 510 before forming the dislocation-blocking mask 520 thereon, such that the regrowth regions 540 merge at the top of the dislocation-blocking mask with pre-defined lattice spacing. This lattice spacing in the regrowth regions follows the lattice spacing of the layer 570 and thus it has less lattice misalignment when two epitaxy structures merge.

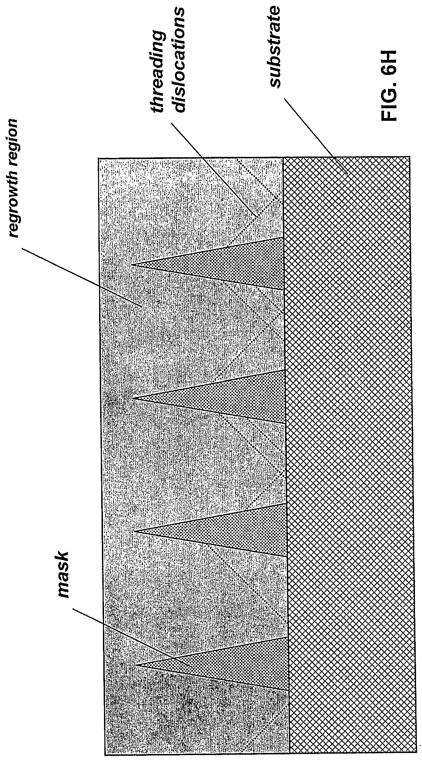

Referring to FIG. 6H, in another version of FIG. 6F, the dislocation-blocking mask defines two or more closely spaced flared openings, such that a horizontal top surface of the mask is minimized or, in certain implementations, eliminated. In this version, the lateral overgrowth region, often prone to defects, is negligible or altogether absent, thereby improving the quality of the resulting merged overgrowth region.

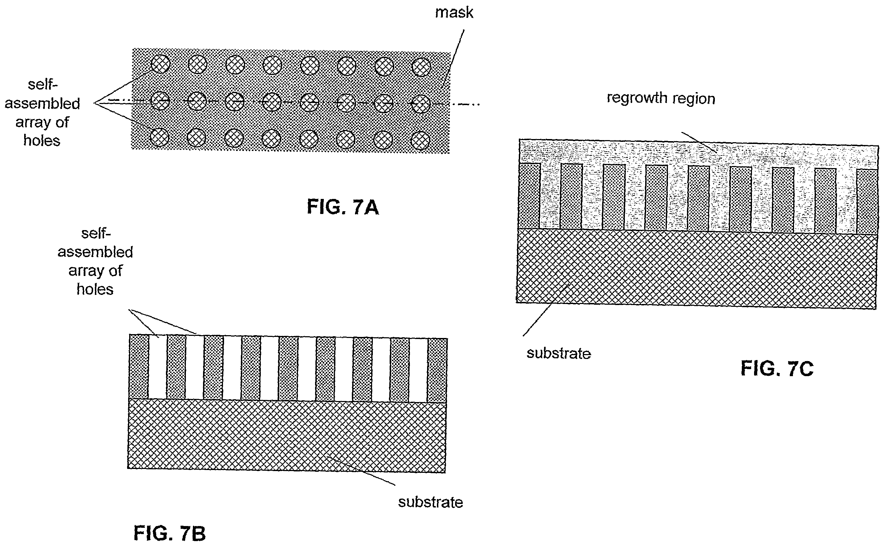

Further, FIGS. 7A- 7C focus on creating large active areas within the heteroepitaxial region by a combination of epitaxial necking and ELO techniques, employing a self-assembled dislocation-blocking mask. Specifically, an dielectric layer defining an array of openings therethrough can be formed using self-assembly techniques, thereby avoiding traditional time-consuming lithography and etch approaches. For an example of how a self-assembled array of vertical openings in an insulator layer could be created on a Si substrate, see an article by Wenchong Hu et al entitled "Growth of well-aligned carbon nanotube arrays on silicon substrates using porous alumina film as a nanotemplate," published in Applied Physics Letters, Vol. 79, No. 19 (2001), describing how anodic oxidation of the aluminum can be used to create a self-assembled array of vertical openings similar to that shown in FIG. 7A-7B, where the insulator is alumina ($Al_2O_3$). The process described by Hu et al., however, leaves a small residual layer of alumina at the bottom of each hole. To remove this residual layer, an anisotropic dry etch (much higher etch rate normal to the wafer surface than parallel to the wafer surface) could be performed, exposing the silicon which is the 'seed' for subsequent epitaxial necking. Then, heteroepitaxial regions are selectively grown within and out of the openings, at least until resulting overgrowth regions coalesce.

Depending on lateral dimensions of the aperture, degree of mismatch, and rigidity of sidewall oxide, either plastic or elastic relaxation of the heteroepitaxial "pillars" may dominate. The resulting heteroepitaxial layer is then planarized (FIG. 7C), e.g. via CMP, and the active-area, substantially exhausted of threading dislocations and/or other dislocation defects is used for device fabrication.

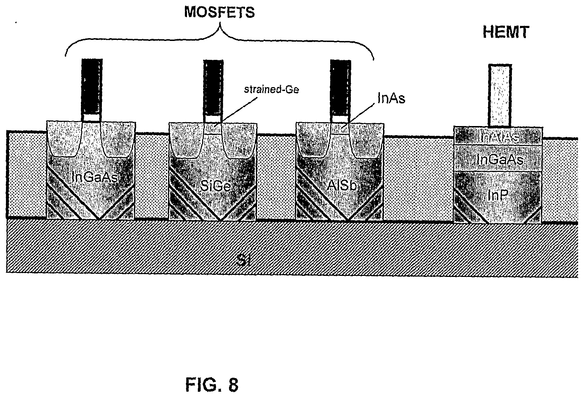

FIGS. 8-10 depict various applications of dislocation-blocking techniques for fabrication of CMOS devices. FIG. 8 shows various device structures disposed over regrowth or overgrown regions fabricated according to the invention, such as MOSFET devices including Ge, InGaAs, strained Ge/SiGe and other materials, or HEMT devices, e.g. including InGaAs. The starting substrate can be Si substrate or SOI /SSOI substrate. In one example, n-FET and p-FET digital devices are fabricated on a SSOI substrate, while RF/analog devices are fabricated over a Ge region grown over the Si substrate using the approaches discussed above. By integrating advanced materials into Si substrate, electron and hole mobility can be enhanced significantly. In order to avoid the deleterious effects of dislocations defects on such FET devices, the channel, source, and drain region should be confined to an upper region of regrowth or overgrown material which is substantially defect-free. As discussed in detail above, blocking of the threading dislocations and other defects is promoted by geometry and orientation of the mask and /or the image force. The image force alone is sufficient to cause the upper region of the regrowth or overgrown material to be substantially exhausted of threading dislocations and other dislocation defects.

Furthermore, still referring to FIG. 8, a wide bandgap material which will suppress junction leakage (such as AlSb) can be used for initial growth, followed by a material with high electron mobility for the FET channel (such as InAs). Preferably, the two semiconductor materials have similar lattice constants, to reduce the possibility of dislocations forming at the interface between them. Also, the growth of the wide bandgap material may be followed by a planarization step so that its surface is substantially planar with the top of the dislocation blocking mask; subsequently a thin layer of the high-mobility material can be grown to accommodate the MOS channel. Preferably, the bottom of the FET junctions is disposed within the wide bandgap region to suppress junction leakage.

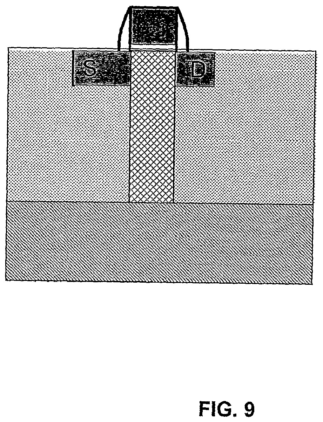

FIG. 9 depicts another application of the dislocation-blocking techniques in CMOS. This method allows the Ge/III-V necking technique to be used in relatively large CMOS devices. When applying the dislocation-blocking technique in a CMOS device of FIG. 8, the length of device active region $L_{active}$ should be small enough to satisfy the aspect ratio requirement discussed above. $L_{active}$, which includes source/drain lengths as well, is, however, much larger than the device channel length Lg. FIG 9 addresses a situation where Ge or GaAs growth is performed at a narrow channel region only;

source/drain materials are then deposited separately. This approach allows for Ge or GaAs growth techniques to be applied to much larger devices, for example, 90 nm node CMOS devices instead of 22 nm node devices. This channel-only Ge/III-V dislocation-blocking approach may also be combined with other desirable source/drain engineering techniques, such as raised source/drain techniques, Schottky source/drain approaches, or the use of materials on the source/drain region different from the material in the channel region for source/drain dopant/conductivity optimization. The quasi source/drain "on-insulator" structure also reduces the junction capacitance. Proper deposition of source/drain materials may also introduce localized strain in the channel region for mobility enhancement purpose. The approach discussed above can be applied to pre-defined small channel regions only. The epitaxial deposition in the source/drain regions may be defective, but as long as the dislocations terminate on the sidewalls of the narrow channel region, the defect density in source/drain is acceptable.

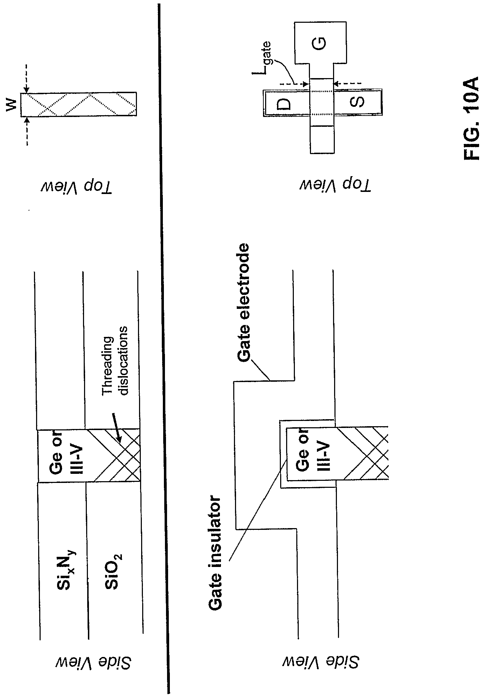

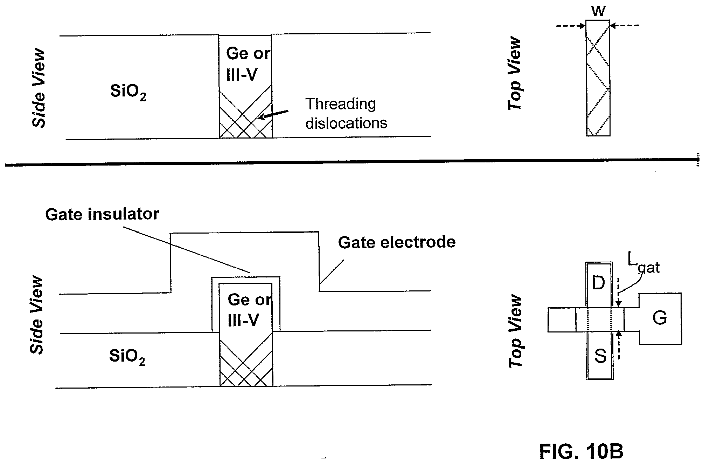

Besides the conventional planar MOSFETs, the dislocation-blocking technique can also be used to fabricate non-planar FETs. As mentioned above, blocking of the threading dislocations and other defects is promoted by geometry and orientation of the mask and/or the image force. The image force alone is sufficient to cause the upper region of the regrowth or overgrown material to be substantially exhausted of threading dislocations and other dislocation defects. FIG. 10A and 10B show body-tied finFETs or tri-gate transistor structures which takes the advantage of the vertical shape of the lattice-mismatched material. One exemplary method includes depositing or growing an oxide layer, followed by depositing a nitride layer, masking and etching a trench of width w< 0.5 h; (the trench orientation may be in a <110> direction, so all the threading dislocations along <110> directions (which will lie at an angle of 45-degrees to the surface of the first semiconductor material) will intersect sidewalls within the height of h); selectively growing Ge or III-V in the trench; chemical-mechanical polishing to remove the portion of selective growth outside of the trench; selectively removing nitride, which results in fin structures; and then growing and/or depositing insulator material around the fin structures; followed by depositing, masking and etching gate electrodes and ion implantation to create source/drain regions. A second exemplary method includes depositing or growing an oxide layer, masking and etching a trench of width w< 0.5 h; selectively growing Ge or III-V in the trench; chemical-mechanical polishing to remove the portion of selective growth outside of the trench; selectively removing a portion of the oxide, which results in fin structures; and then growing and/or depositing insulator material around the fin structures; followed by depositing, masking and etching gate electrodes and ion implantation to create source/drain regions.

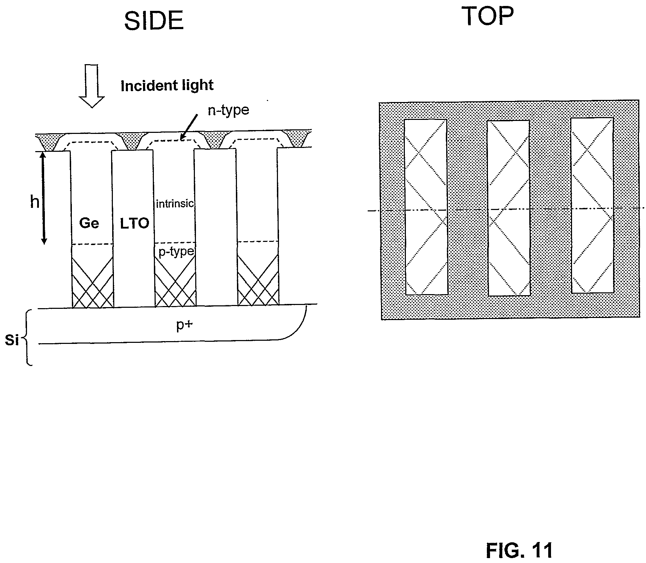

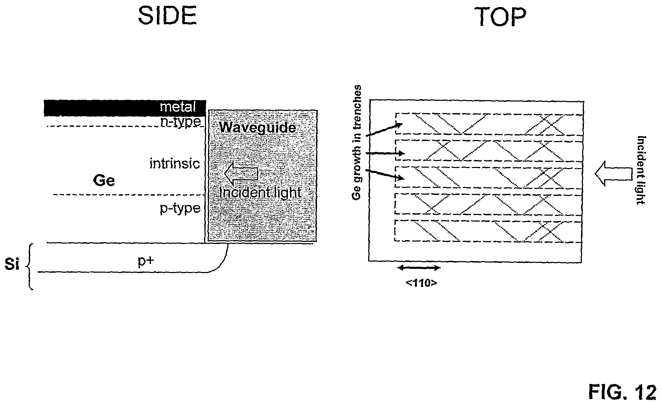

Besides FET devices, the dislocation-blocking techniques can also be used to fabricate other types of devices, such as optical devices. Referring to FIGS. 11-12, Ge or III-V photodetectors are integrated into a Si substrate using such techniques. In FIG. 11, a lower contact is implanted on a Si substrate to form p+-type region; low-temperature oxide is deposited; apertures or trenches are etched through the low-temperature oxide layer to explore the Si substrate; and Ge or III-V materials are selectively grown on the apertures or trenches with in-situ doping until past the defect regions (p-type). Further, epitaxial growth continues until the thickness is sufficient to allow for desirable levels of absorption of incident light, and then the top layer is implanted to form an n-type region. In another configuration, the light comes from the side (e.g. from in-plane waveguide) instead of from the top, as shown in FIG. 12. This allows light detection to occur in-plane with the wafer surface and also to allow growth thickness to be independent of absorption depth.

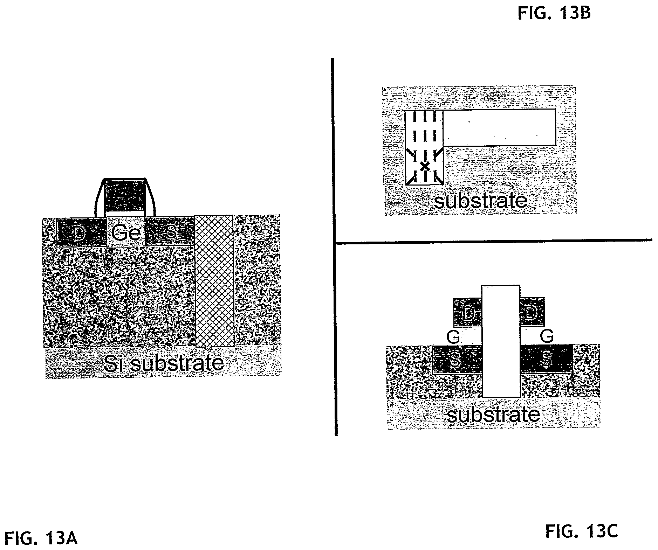

In various examples described above, the dislocation-blocking is performed in a vertical direction. FIG. 13A shows an alternative example where the dislocation-blocking may conduct in a lateral direction, for example from the source or drain region. Therefore, the device can be an SOI structure. In one embodiment, the gate oxide and gate stack can be formed first, before the dislocation-blocking growth under the gate, using a channel-replacement-type process. This approach addresses the self-alignment issue and any surface roughness issues.

FIG. 13B shows another method which allows dislocations be terminated for a large size epitaxial area. The method includes two steps of epitaxial growth, which take different growth directions, so that the dislocations in one direction terminate at the sidewall during the first epitaxial growth, and the dislocations in another direction, which may have large device dimensions, can terminate on the sidewall when the epitaxial growth changes the direction.

Conventional Ge/III-V necking forms crystal material in the vertical direction. Therefore, when building planar MOS or finFET type devices on that crystal, the device is typically a bulk-type or body-tied, not an "on-insulator" structure. Bulk-type of Ge or GaAs FET may exhibit large junction leakage and poor short-channel effect control. One solution is to build the device vertically instead of parallel to horizontal surface. FIG. 13C shows one example of such structure: a vertical-channel FET, which incorporates the benefits that a vertical FET has, for example, SCE control, better scalability, etc. Another approach is to epitaxially grow an oxide layer that is lattice-matched to the second semiconductor material during selective deposition of the second semiconductor material. As result, there is an oxide layer within the regrowth region underlying a portion thereof subsequently used for device fabrication, as discussed in more detail in co-pending U.S. Patent Application Serial No. 11/000,566 by Currie.

**Claims**

1. A method of forming a semiconductor heterostructure, the method comprising:

   (a) providing a substrate having a surface and comprising a first semiconductor material;
   (b) providing a dislocation-blocking mask over the substrate, the mask comprising a dielectric material and having a rectangular trench extending to the surface of the substrate and defined by at least one sidewall at least a portion of which meets the surface of the substrate at an orientation angle to a selected crystallographic direction of the first semiconductor material, the trench having a predetermined width W smaller than a length L thereof; and
   (c) depositing in the trench a regrowth layer comprising a second semiconductor material, the orientation angle causing threading dislocations in the regrowth layer to terminate at the sidewall and to decrease in density with increasing distance from the surface of the substrate,

   wherein (i) the sidewall of the trench has a height at least equal to a predetermined distance H from the surface of the substrate, (ii) the threading dislocations terminate at the sidewall of the trench in the dislocation-blocking mask at or below the predetermined distance H, and (iii) the sidewall of the trench comprises:

   a first portion disposed above the surface of the substrate and having a height at least equal to the predetermined distance H from the surface of the substrate, said first portion of the sidewall being vertical, and
   a second portion disposed above the first portion, sloped with respect to the surface of the substrate and flared outwardly.

2. The method of claim 1, further comprising depositing an overgrowth layer comprising the second semiconductor material over the regrowth layer and over at least a portion of the dislocation-blocking mask.

3. The method of claim 1 wherein the first semiconductor material comprises silicon or a silicon germanium alloy.

4. The method of claim 1 wherein the second semiconductor material is selected from the group consisting of germanium, silicon germanium, gallium arsenide, aluminum antimonide, indium aluminum antimonide, indium antimonide, indium arsenide, indium phosphide and gallium nitride.

5. The method of claim 1 wherein the selected crystallographic direction of the first semiconductor material is aligned with at least one direction of propagation of threading dislocations in the regrowth layer.

6. The method of claim 5 wherein the orientation angle ranges from 30 to 60 degrees.

7. The method of claim 1 wherein the surface of the substrate has a crystallographic orientation selected from the group consisting of: (100), (110), and (111).

8. The method of claim 7 wherein the selected crystallographic direction is aligned with a <110> crystallographic direction of the first semiconductor material.

9. The method of claim 7 wherein the portion of the sidewall meets the surface of the substrate in alignment with a <100> crystallographic direction of the first semiconductor material.

10. The method of claim 1 wherein the first semiconductor material is non-polar, the second semiconductor material is polar, and the orientation angle causes anti-phase boundaries in the regrowth layer to decrease in density with increasing distance from the surface of the substrate.

11. The method of claim 1 wherein the orientation angle causes stacking faults in the regrowth layer to decrease in density with increasing distance from the surface of the substrate.

12. The method of claim 1 wherein the orientation angle causes twin boundaries in the regrowth layer to decrease in density with increasing distance from the surface of the substrate

13. The method of claim 1, further comprising planarizing the regrowth layer such that, following the planarizing step, a planarized surface of regrowth layer is co-planar with a top surface of the dislocation-blocking mask.

14. The method of claim 1 wherein the width W of the trench is less than 500 nm.

15. The method of claim 14 wherein the length L of the trench exceeds each of W and H.

16. The method of claim 1, further comprising depositing a lattice-mismatched layer over at least a portion of the substrate prior to providing the dislocation-blocking mask thereon, the lattice-mismatched layer comprising a third semiconductor material and being at least partially relaxed.

17. The method of claim 16, further comprising planarizing the lattice-mismatched layer prior to providing the dislocation-blocking mask.

18. A semiconductor structure comprising:

(a) a substrate having a surface and comprising a first semiconductor material;
(b) a dislocation-blocking mask disposed over the substrate, the mask comprising a dielectric material and having a rectangular trench extending to the surface of the substrate, the trench being defined by at least one sidewall at least a portion of which meets the surface of the substrate at an orientation angle to a selected crystallographic direction of the first semiconductor material, the sidewall having a height h at least equal to a predetermined distance H from the surface of the substrate, the trench being rectangular and having a predetermined width W; and
(c) a regrowth layer comprising a second semiconductor material formed in the trench,

wherein i) dislocation defects in the regrowth layer terminate at the sidewall of the trench at or below predetermined distance H; and

ii) the sidewall of the trench comprises:

a first portion disposed above the surface of the substrate and having a height at least equal to the predetermined distance H from the surface of the substrate, the first portion of the sidewall being vertical, and
a second portion disposed above the first portion, sloped with respect to the surface of the substrate and flared outwardly.

19. The structure of claim 18 wherein the first semiconductor material is non-polar, the second semiconductor material is polar, and the orientation angle causes anti-phase boundaries in the regrowth layer to decrease in density with increasing distance from the surface of the substrate.

20. The structure of claim 18, further comprising an overgrowth layer comprising the second semiconductor material disposed over the regrowth layer and over at least a portion of the dislocation-blocking mask.

21. A semiconductor device comprising a structure of claim 18, the regrowth region of the structure including:

i. a first portion formed in the trench comprising a second semiconductor material and disposed above the surface of the substrate, dislocation defects in the regrowth region terminating in the first portion; and

ii. a second portion disposed above the first portion, the second portion comprising a third semiconductor material;

the device also comprising:

(a) a channel region disposed in the second portion of the regrowth region; and
(b) a source region and a drain region, the channel region being disposed therebetween.

22. The device of claim 21 wherein the first semiconductor material comprises silicon.

23. The device of claim 21 wherein the semiconductor substrate comprises:

(a) a silicon wafer;
(b) a compositionally uniform relaxed $Si_{1-x}Ge_x$ layer deposited thereon; and
(c) a strained silicon layer deposited on the relaxed $Si_{1-x}Ge_x$ layer.

24. The device of claim 21, further comprising a lattice-mismatched layer disposed between at least a portion of the substrate and the dislocation-blocking mask, the lattice-mismatched layer comprising a second semiconductor material and being at least partially relaxed.

25. The device of claim 21 wherein the first portion of the regrowth region comprises silicon germanium and the second portion of the regrowth region comprises a layer of strained germanium.

26. The device of claim 21 wherein the first portion of the regrowth region comprises indium phosphide and the second portion of the regrowth region comprises a layer of indium gallium arsenide disposed over a layer of indium aluminum arsenide.

27. The device of claim 21, wherein a width of the trench is less than 500 nm.

**Patentansprüche**

1. Verfahren zum Bilden einer Halbleiterheterostruktur, wobei das Verfahren Folgendes umfasst:

(a) Bereitstellen eines Substrats, das eine Oberfläche aufweist, die ein erstes Halbleitermaterial umfasst;
(b) Bereitstellen einer Versetzungsblockierungsmaske über dem Substrat, wobei die Maske ein dielektrisches Material umfasst, das eine rechteckige Vertiefung aufweist, die sich zu der Oberfläche des Substrats erstreckt und durch zumindest eine Seitenwand definiert ist, von der zumindest ein Abschnitt in einem Ausrichtungswinkel zu einer ausgewählten kristallographischen Richtung des ersten Halbleitermaterials auf der Oberfläche des Substrats auftrifft, wobei die Vertiefung eine vorbestimmte Breite W aufweist, die kleiner ist als eine Länge L davon; und
(c) Aufbringen einer Nachwachsschicht, die ein zweites Halbleitermaterial umfasst, in der Vertiefung, wobei der Ausrichtungswinkel zu Gewindeversetzungen in der Nachwachsschicht führt, die an der Seitenwand enden und deren Dichte mit zunehmendem Abstand von der Oberfläche des Substrats abnimmt,

wobei (i) die Seitenwand der Vertiefung eine Höhe aufweist, die zumindest gleich einer vorbestimmten Entfernung H von der Oberfläche des Substrats ist, (ii) die Gewindeversetzungen an der Seitenwand der Vertiefung in der Versetzungsblockierungsmaske an oder unter der vorbestimmten Entfernung H enden und (iii) die Seitenwand der Vertiefung Folgendes umfasst:

einen ersten Abschnitt, der über der Oberfläche des Substrats angeordnet ist und der eine Höhe aufweist, die zumindest gleich der vorbestimmten Entfernung H von der Oberfläche des Substrats ist, wobei der erste Abschnitt der Seitenwand vertikal ist, und
einen zweiten Abschnitt, der über dem ersten Abschnitt angeordnet ist, der in Bezug auf die Oberfläche des Substrats geneigt und nach außen aufgeweitet ist.

2. Verfahren nach Anspruch 1, das ferner das Aufbringen einer Überwachsungsschicht, die das zweite Halbleitermaterial umfasst, über der Nachwachsschicht und über zumindest einem Abschnitt der Versetzungsblockierungsmaske umfasst.

3. Verfahren nach Anspruch 1, wobei das erste Halbleitermaterial Silizium oder eine Silizium-Germanium-Legierung umfasst.

4. Verfahren nach Anspruch 1, wobei das zweite Halbleitermaterial aus der Gruppe bestehend aus Germanium, Siliziumgermanium, Galliumarsenid, Aluminiumantimonid, Indiumaluminiumantimonid, Indiumantimonid, Indiumarsenid, Indiumphosphid und Galliumnitrid ausgewählt ist.

5. Verfahren nach Anspruch 1, wobei die ausgewählte kristallographische Richtung des ersten Halbleitermaterials mit zumindest einer Ausbreitungsrichtung von Gewindeversetzungen in der Nachwachsschicht ausgerichtet ist.

**6.** Verfahren nach Anspruch 5, wobei der Ausrichtungswinkel in einem Bereich zwischen 30 und 60 Grad liegt.

**7.** Verfahren nach Anspruch 1, wobei die Oberfläche des Substrats eine kristallographische Ausrichtung aufweist, die aus der Gruppe bestehend aus Folgendem ausgewählt ist: (100), (110) und (111).

**8.** Verfahren nach Anspruch 7, wobei die ausgewählte kristallographische Richtung mit einer <110> kristallographischen Richtung des ersten Halbleitermaterials ausgerichtet ist.

**9.** Verfahren nach Anspruch 7, wobei der Abschnitt der Seitenwand in Ausrichtung mit einer <100> kristallographischen Richtung des ersten Halbleitermaterials auf die Oberfläche des Substrats auftrifft.

**10.** Verfahren nach Anspruch 1, wobei das erste Halbleitermaterial unpolar ist, das zweite Halbleitermaterial polar ist und der Ausrichtungswinkel zu gegenphasigen Grenzen in der Nachwachsschicht führt, deren Dichte mit zunehmendem Abstand von der Oberfläche des Substrats abnimmt.

**11.** Verfahren nach Anspruch 1, wobei der Ausrichtungswinkel zu Stapelfehlern in der Nachwachsschicht führt, deren Dichte mit zunehmendem Abstand von der Oberfläche des Substrats abnimmt.

**12.** Verfahren nach Anspruch 1, wobei der Ausrichtungswinkel zu Zwillingsgrenzen in der Nachwachsschicht führt, deren Dichte mit zunehmendem Abstand von der Oberfläche des Substrats abnimmt.

**13.** Verfahren nach Anspruch 1, das ferner das Planarisieren der Nachwachsschicht umfasst, sodass nach dem Planarisierungsschritt eine planarisierte Oberfläche der Nachwachsschicht koplanar mit einer Oberseite der Versetzungsblockierungsmaske ist.

**14.** Verfahren nach Anspruch 1, wobei die Breite W der Vertiefung unter 500 nm liegt.

**15.** Verfahren nach Anspruch 14, wobei die Länge L der Vertiefung sowohl W als auch H überschreitet.

**16.** Verfahren nach Anspruch 1, das ferner das Aufbringen einer gitterfehlangepassten Schicht über zumindest einem Abschnitt des Substrats vor dem Bereitstellen der Versetzungsblockierungsmaske darauf umfasst, wobei die gitterfehlangepasste Schicht ein drittes Halbleitermaterial umfasst und zumindest teilweise entspannt ist.

**17.** Verfahren nach Anspruch 16, das ferner das Planarisieren der gitterfehlangepassten Schicht vor dem Bereitstellen der Versetzungsblockierungsmaske umfasst.

**18.** Halbleiterstruktur, umfassend:

(a) ein Substrat, das eine Oberfläche aufweist, die ein erstes Halbleitermaterial umfasst;
(b) eine Versetzungsblockierungsmaske, die über dem Substrat angeordnet ist, wobei die Maske ein dielektrisches Material umfasst und eine rechteckige Vertiefung aufweist, die sich zu der Oberfläche des Substrats erstreckt, wobei die Vertiefung durch zumindest eine Seitenwand definiert ist, von der zumindest ein Abschnitt in einem Ausrichtungswinkel zu einer ausgewählten kristallographischen Richtung des ersten Halbleitermaterials auf die Oberfläche des Substrats auftrifft, wobei die Seitenwand eine Höhe h aufweist, die zumindest gleich einer vorbestimmten Entfernung H von der Oberfläche des Substrats ist, wobei die Vertiefung rechteckig ist und eine vorbestimmte Breite W aufweist; und
(c) eine Nachweisschicht, die ein zweites, in der Vertiefung gebildetes Halbleitermaterial umfasst, wobei

i) Versetzungsfehler in der Nachweisschicht an der Seitenwand der Vertiefung an oder unter einer vorbestimmten Entfernung H enden; und
ii) die Seitenwand der Vertiefung Folgendes umfasst:

einen ersten Abschnitt, der über der Oberfläche des Substrats angeordnet ist und der eine Höhe aufweist, die zumindest gleich der vorbestimmten Entfernung H von der Oberfläche des Substrats ist, wobei der erste Abschnitt der Seitenwand vertikal ist, und
einen zweiten Abschnitt, der über dem ersten Abschnitt angeordnet ist, der in Bezug auf die Oberfläche des Substrats geneigt und nach außen aufgeweitet ist.

**19.** Struktur nach Anspruch 18, wobei das erste Halbleitermaterial unpolar ist, das zweite Halbleitermaterial polar ist und der Ausrichtungswinkel zu gegenphasigen Grenzen in der Nachwachsschicht führt, deren Dichte mit zunehmendem Abstand von der Oberfläche des Substrats abnimmt.

**20.** Struktur nach Anspruch 18, die ferner eine Überwachsungsschicht umfasst, die das zweite Halbleitermaterial umfasst, das über der Nachwachsschicht und zumindest über einem Abschnitt der Versetzungsblockierungsmaske angeordnet ist.

**21.** Halbleitervorrichtung, die eine Struktur nach Anspruch 18 umfasst, wobei der Nachwachsbereich der Struktur Folgendes einschließt:

    i. einen ersten Abschnitt, der in der Vertiefung gebildet ist, die ein zweites Halbleitermaterial umfasst und über der Oberfläche des Substrats angeordnet ist, wobei Versetzungsfehler in dem Nachwachsbereich in dem ersten Abschnitt enden; und
    ii. einen zweiten Abschnitt, der über dem ersten Abschnitt angeordnet ist, wobei der zweite Abschnitt ein drittes Halbleitermaterial umfasst; wobei die Vorrichtung außerdem Folgendes umfasst:

        (a) einen Kanalbereich, der in dem zweiten Abschnitt des Nachweisbereichs angeordnet ist; und
        (b) einen Sourcebereich und einen Drainbereich, wobei der Kanalbereich dazwischen angeordnet ist.

**22.** Vorrichtung nach Anspruch 21, wobei das erste Halbleitermaterial Silizium umfasst.

**23.** Vorrichtung nach Anspruch 21, wobei das Halbleitersubstrat Folgendes umfasst:

    (a) einen Siliziumwafer;
    (b) eine zusammensetzungsgemäß einheitliche entspannte $Si_{1-x}Ge_x$-Schicht, die darauf angeordnet ist; und
    (c) eine verspannte Siliziumschicht, die auf der entspannten $Si_{1-x}Ge_x$-Schicht angeordnet ist.

**24.** Vorrichtung nach Anspruch 21, die ferner eine gitterfehlangepasste Schicht umfasst, die zwischen zumindest einem Abschnitt des Substrats und der Versetzungsblockierungsmaske angeordnet ist, wobei die gitterfehlangepasste Schicht ein zweites Halbleitermaterial umfasst und zumindest teilweise entspannt ist.

**25.** Vorrichtung nach Anspruch 21, wobei der erste Abschnitt der Nachwachsschicht Siliziumgermanium umfasst und der zweite Abschnitt der Nachwachsschicht eine Schicht aus verspanntem Germanium umfasst.

**26.** Vorrichtung nach Anspruch 21, wobei der erste Abschnitt der Nachwachsschicht Indiumphosphid umfasst und der zweite Abschnitt der Nachwachsschicht eine Schicht aus Indiumgalliumarsenid umfasst, die über einer Schicht aus Indiumaluminiumarsenid angeordnet ist.

**27.** Vorrichtung nach Anspruch 21, wobei eine Breite der Vertiefung unter 500 nm liegt.

**Revendications**

**1.** Procédé de formation d'une hétérostructure à semi-conducteur, le procédé comprenant :

    (a) la fourniture d'un substrat ayant une surface et comprenant un premier matériau semi-conducteur ;
    (b) la fourniture d'un masque de dislocation de blocage sur le substrat, le masque comprenant un matériau diélectrique et présentant une tranchée rectangulaire se prolongeant jusqu'à la surface du substrat et définie par au moins une paroi latérale d'au moins une partie qui rejoint la surface du substrat à un angle d'orientation par rapport à une direction cristallographique sélectionnée du premier matériau semi-conducteur, la tranchée ayant une largeur W prédéterminée inférieure à une longueur L de celle-ci ; et
    (c) le dépôt dans la tranchée d'une couche de repousse comprenant un deuxième matériau semi-conducteur, l'angle d'orientation provoquant des dislocations de filetage dans la couche de repousse pour terminer la paroi latérale et réduire la densité au fur que la distance croît par rapport à la surface du substrat,

où (i) la paroi latérale de la tranchée a une hauteur au moins égale à une distance prédéterminée H de la surface du substrat, (ii) les dislocations de filetage se terminent au niveau de la paroi latérale de la tranchée dans le masque de blocage de dislocation au niveau ou au-dessous de la distance prédéterminée H, et (iii) la paroi latérale de la tranchée comprend :

    une première partie disposée au-dessus de la surface du substrat et ayant une hauteur au moins égale à la distance prédéterminée H de la surface du substrat, ladite première partie de la paroi latérale étant verticale, et
    une deuxième partie disposée au-dessus de la première partie, inclinée par rapport à la surface du substrat et évasée vers l'extérieur.

**2.** Procédé selon la revendication 1, comprenant en outre le dépôt d'une couche de recouvrement comprenant le deuxième matériau semi-conducteur sur la couche de repousse et sur au moins une partie du masque de blocage de dislocation.

**3.** Procédé selon la revendication 1, dans lequel le premier matériau semi-conducteur comprend du silicium ou un alliage de silicium germanium.

**4.** Procédé selon la revendication 1, dans lequel le deuxième matériau semi-conducteur est choisi dans le groupe comprenant le germanium, le silicium de germanium, l'arséniure de gallium, l'antimoniure d'aluminium, l'antimoniure d'indium d'aluminium, l'antimoniure d'indium, l'arséniure d'indium, le phosphure d'indium et le nitrure de gallium.

**5.** Procédé selon la revendication 1, dans lequel la direction cristallographique sélectionnée du premier matériau semi-conducteur est alignée avec au moins une direction de propagation des dislocations de filetage dans la couche de repousse.

**6.** Procédé selon la revendication 5, dans lequel l'angle d'orientation est compris entre 30 et 60 degrés.

**7.** Procédé selon la revendication 1, dans lequel la surface du substrat a une orientation cristallographique choisie dans le groupe comprenant : (100), (110) et (111).

**8.** Procédé selon la revendication 7, dans lequel la direction cristallographique sélectionnée est alignée avec une direction cristallographique <110> du premier matériau semi-conducteur.

**9.** Procédé selon la revendication 7, dans lequel la partie de la paroi latérale rejoint la surface du substrat en alignement avec une direction cristallographique <100> du premier matériau semi-conducteur.

**10.** Procédé selon la revendication 1, dans lequel le premier matériau semi-conducteur est non-polaire, le deuxième matériau semi-conducteur est polaire et l'angle d'orientation provoque des limites en opposition de phase dans la couche de repousse pour baisser de densité au fur et à mesure qu'augmente la distance à partir de la surface du substrat.

**11.** Procédé selon la revendication 1, dans lequel l'angle d'orientation provoque des défauts d'empilement dans la couche de repousse au fur et à mesure qu'augmente la distance à partir de la surface du substrat.

**12.** Procédé selon la revendication 1, dans lequel l'angle d'orientation provoque des limites doubles dans la couche de repousse au fur et à mesure qu'augmente la distance à partir de la surface du substrat.

**13.** Procédé selon la revendication 1, comprenant en outre la planarisation de la couche de repousse de telle sorte que, après l'étape de planarisation, une surface aplanie de la couche de repousse est coplanaire avec une surface supérieure du masque de blocage de dislocation.

**14.** Procédé selon la revendication 1, dans lequel la largeur W de la tranchée est inférieure à 500 nm.

**15.** Procédé selon la revendication 14, dans lequel la longueur L de la tranchée est supérieure à chacune de W et H.

**16.** Procédé selon la revendication 1, comprenant en outre le dépôt d'une couche mésappariée en treillis sur au moins une partie du substrat avant la fourniture du masque de blocage de dislocation sur celui-ci, la couche mésappariée en treillis comprenant un troisième matériau semi-conducteur et étant au moins partiellement relâchée.

**17.** Procédé selon la revendication 16, comprenant en outre la planarisation de la couche mésappariée en treillis avant la fourniture du masque de dislocation de blocage.

**18.** Structure semi-conductrice comprenant :

(a) un substrat ayant une surface et comprenant un premier matériau semi-conducteur ;
(b) un masque de dislocation de blocage disposé sur le substrat, le masque comprenant un matériau diélectrique et présentant une tranchée rectangulaire se prolongeant jusqu'à la surface du substrat, la tranchée étant définie par au moins une paroi latérale d'au moins une partie qui rejoint la surface du substrat à un angle d'orientation par rapport à une direction cristallographique sélectionnée du premier matériau semi-conducteur, la paroi latérale ayant une hauteur h au moins égale à une distance prédéterminée H à partir de la surface du substrat, la tranchée étant rectangulaire et présentant une largeur prédéterminée W ; et
(c) une couche de repousse comprenant un second matériau semi-conducteur formé dans la tranchée, où

i) les défauts de dislocation dans la couche de repousse se terminent au niveau de la paroi latérale de la tranchée à une distance prédéterminée H ou en dessous de celle-ci ; et
ii) la paroi latérale de la tranchée comprend :

une première partie disposée au-dessus de la surface du substrat et ayant une hauteur au moins égale à la distance prédéterminée H de la surface du substrat, ladite première partie de la paroi latérale étant verticale, et

une seconde partie disposée au-dessus de la première partie, inclinée par rapport à la surface du substrat et évasée vers l'extérieur.

**19.** Structure selon la revendication 18, dans lequel le premier matériau semi-conducteur est non-polaire, le deuxième matériau semi-conducteur est polaire et l'angle d'orientation provoque des limites en opposition de phase dans la couche de repousse pour baisser de densité au fur et à mesure qu'augmente la distance à partir de la surface du substrat.

**20.** Structure selon la revendication 18, comprenant en outre une couche de recouvrement comprenant le deuxième matériau semi-conducteur disposé sur la couche de repousse et sur au moins une partie du masque de blocage de dislocation.

**21.** Dispositif semi-conducteur comprenant une structure selon la revendication 18, la zone de repousse de la structure comprenant :

   i. une première partie formée dans la tranchée comprenant un deuxième matériau semi-conducteur et disposé au-dessus de la surface du substrat, des défauts de dislocation dans la zone de repousse se terminant dans la première partie ; et
   ii. une deuxième partie disposée au-dessus de la première partie, la deuxième partie comprenant un troisième matériau semi-conducteur ;

   le dispositif comprenant également :

   (a) une zone de canal disposée dans la deuxième partie de la zone de repousse ; et
   (b) une zone de source et une zone de drain, la zone de canal étant disposée entre celles-ci.

**22.** Dispositif selon la revendication 21, dans lequel le premier matériau semi-conducteur comprend du silicium.

**23.** Dispositif selon la revendication 21, dans lequel le substrat semi-conducteur comprend :

   (a) une galette de silicium ;
   (b) une couche de $Si_{1-x}Ge_x$ relâchée de manière uniforme de par sa composition et déposée sur celui-ci ; et
   (c) une couche de silicium contrainte déposée sur la couche de $Si_{1-x}Ge_x$ relâchée.

**24.** Dispositif selon la revendication 21, comprenant en outre le dépôt d'une couche mésappariée en treillis entre au moins une partie du substrat et le masque de blocage de dislocation, la couche mésappariée en treillis comprenant un deuxième matériau semi-conducteur et étant au moins partiellement relâchée.

**25.** Dispositif selon la revendication 21, dans lequel la première partie de la zone de repousse comprend du germanium de silicium et la deuxième partie de la zone de repousse comprend une couche de germanium contraint.

**26.** Dispositif selon la revendication 21, dans lequel la première partie de la zone de repousse comprend du phosphure d'indium et la deuxième partie de la zone de repousse comprend une couche d'arséniure d'indium gallium disposée sur une couche d'arséniure d'aluminium indium.

**27.** Dispositif selon la revendication 21, dans lequel une largeur de la tranchée est inférieure à 500 nm.

FIG. 1A

FIG. 1B

CRYSTAL PLANE

(A)    (B)    (C)

FIG. 2

**FIG. 3A**

**FIG. 3B**

EP 1 882 268 B1

epilayer

<110>

45°

<100>

<110>

(100) substrate

**FIG. 4A**

{100}

THREADING
SEGMENT

MISFIT
SEGMENT

<100>

<110>

**FIG. 4B**

FIG. 4C

FIG. 4D

regrowth region

mask

threading dislocations

substrate

FIG. 4E

EP 1 882 268 B1

**Si (111) surfaces**

mask

Si (100) substrate

**FIG. 5A**

regrowth region

Si (100) substrate

**FIG. 5B**

**FIG. 6A**

**FIG. 6B**

FIG. 6C

FIG. 6D

**FIG. 6E**

560

520

510

540

**FIG. 6F**

540

560

520

570

510

**FIG. 6G**

mask

regrowth region

threading
dislocations

substrate

FIG. 6H

mask

self-
assembled
array of
holes

**FIG. 7A**

regrowth region

self-
assembled
array of
holes

substrate

**FIG. 7C**

substrate

**FIG. 7B**

EP 1 882 268 B1

MOSFETS

HEMT

strained-Ge

InAs

InGaAs

SiGe

AlSb

InAlAs

InGaAs

InP

Si

FIG. 8

FIG. 9

Side View

Si$_x$N$_y$

Ge or III-V

SiO$_2$

Threading dislocations

Top View

W

Gate insulator

Gate electrode

Side View

Ge or III-V

Top View

L$_{gate}$

D

G

S

FIG. 10A

FIG. 10B

## SIDE

Incident light

n-type

h

Ge   LTO   intrinsic

p-type

Si {

p+

## TOP

FIG. 11

FIG. 12

TOP

Incident light

Ge growth in trenches

<110>

SIDE

Waveguide

Incident light

metal
n-type
intrinsic
p-type

Ge

p+

Si

FIG. 13A

FIG. 13B

FIG. 13C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5221413 A
- US 20040045499 A, Langdo
- US 000566 A, Currie

### Non-patent literature cited in the description

- **CHOI et al.** Monolithic Integration of Si MOSFET's and GaAs MESFET's. *IEEE Electron Device Letters,* April 1986, vol. EDL-7 (4
- **CHOI et al.** Monolithic Integration of GaAs/AlGaAs Double-Heterostructure LED's and Si MOSFET's. *IEEE Electron Device Letters,* September 1986, vol. EDL-7 (9
- **SHICHIJO et al.** Co-Integration of GaAs MESFET and Si CMOS Circuits. *IEEE Electron Device Letters,* September 1988, vol. 9 (9
- **CHOI et al.** Monolithic Integration of GaAs/AlGaAs LED and Si Driver Circuit. *IEEE Electron Device Letters,* October 1988, vol. 9 (10), 513
- **LANGDO et al.** High Quality Ge on Si by Epitaxial Necking. *Applied Physics Letters,* April 2000, vol. 76 (25
- Introduction to Dislocations. **HULL ; BACON.** Steel Times. 2001
- **WENCHONG HU et al.** Growth of well-aligned carbon nanotube arrays on silicon substrates using porous alumina film as a nanotemplate. *Applied Physics Letters,* 2001, vol. 79 (19